(19) Europäisches Patentamt / European Patent Office / Office européen des brevets

(11) EP 3 455 326 B1

(12) # EUROPÄISCHE PATENTSCHRIFT

(45) Veröffentlichungstag und Bekanntmachung des Hinweises auf die Patenterteilung:
**24.02.2021 Patentblatt 2021/08**

(21) Anmeldenummer: **17721178.6**

(22) Anmeldetag: **08.05.2017**

(51) Int Cl.:
***C09K 11/06*** *(2006.01)* ***H01B 1/08*** *(2006.01)*
***H01B 1/12*** *(2006.01)* ***H01L 51/50*** *(2006.01)*
***C08G 73/02*** *(2006.01)* ***H01L 51/00*** *(2006.01)*

(86) Internationale Anmeldenummer:
**PCT/EP2017/060858**

(87) Internationale Veröffentlichungsnummer:
**WO 2017/194435 (16.11.2017 Gazette 2017/46)**

(54) **ZUSAMMENSETZUNGEN FÜR ELEKTROCHEMISCHE ZELLEN**

COMPOSITIONS FOR ELECTROCHEMICAL CELLS

COMPOSITIONS POUR CELLULES ÉLECTROCHIMIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.05.2016 EP 16169164**

(43) Veröffentlichungstag der Anmeldung:
**20.03.2019 Patentblatt 2019/12**

(73) Patentinhaber: **Merck Patent GmbH**
**64293 Darmstadt (DE)**

(72) Erfinder:
- **BUCHHOLZ, Herwig**
**60599 Frankfurt am Main (DE)**
- **PAN, Junyou**
**60320 Frankfurt am Main (DE)**

(56) Entgegenhaltungen:
**EP-A1- 2 733 188**
**EP-A1- 2 958 403**
**WO-A1-2011/053236**
**WO-A2-2014/094965**
**DE-A1-102008 033 563**
**DE-A1-102011 104 169**
**US-A1- 2014 291 590**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft eine Zusammensetzung umfassend zumindest eine neutrale organische lumineszierende Verbindung sowie zumindest eine ionische Verbindung. Weiter betrifft die Erfindung eine lichtemittierende elektrochemische Zelle, welche diese Zusammensetzung enthält.

Lichtemittierende elektronische Bauteile halten zunehmend als Lichtquellen in den Alltag Einzug. Sie weisen als Vorteile einen niedrigen Energieverbrauch, eine kompakte Bauweise und eine im Vergleich zu herkömmlichen Leuchtmitteln deutlich längere Lebenszeit auf. Waren es zunächst anorganische lichtemittierende Dioden, die als Leuchtmittel eingesetzt wurden, finden in jüngerer Zeit auch organische lichtemittierende Dioden (OLED) Anwendung in Gegenständen des täglichen Gebrauchs, wie beispielsweise in Displays für Mobiltelefone. Vorteile der OLEDs gegenüber ihren anorganischen Äquivalenten bestehen in ihrer einfacheren Verarbeitbarkeit. Die in OLEDs eingesetzten Materialien lassen sich in geeigneten Lösungsmitteln lösen. Die einzelnen Schichten der Bauelemente lassen sich beispielsweise mittels Druckverfahren auf ein Substrat aufbringen. Es ist daher vergleichsweise einfach, gebogene Displays herzustellen. Da die Schichten nicht kristallin ausgebildet sind, sind OLEDs im Vergleich zu LEDs auf der Basis anorganischer Verbindungen flexibel und lassen sich daher auch auf flexiblen Substraten für die Herstellung flexibler Bildschirme aufbringen. OLEDs emittieren selbst Licht und benötigen daher keine Hintergrundbeleuchtung, wie sie etwa bei Flüssigkristallanzeigen (CD) erforderlich ist. Dadurch lassen sich Bildschirme auf der Basis von OLEDs sehr dünn ausgestalten. Als weiterer Vorteil zeigen Displays auf der Basis von OLEDs einen sehr hohen Kontrast, da nicht angeregte OLEDs kein Licht aussenden, also vollkommen schwarz sind. Bei der Lichtausbeute konnten große Fortschritte erreicht werden, sodass es nun möglich ist, die zum Anregen elektronischer Zustände der OLED eingesetzte Energie nahezu vollständig in Licht umzuwandeln.

OLEDs sind aus mehreren Schichten aufgebaut. Auf einem Substrat, welches vorzugsweise transparent ist, beispielsweise einer Glasplatte oder einer transparenten Kunststofffolie, wird zunächst eine Anode aufgebracht. Hier wird meist Indium-Zinn-Oxid (ITO) verwendet, um eine transparente Anode zu erhalten. Auf der Anode wird dann eine Lochleitungsschicht (HTL = "hole transport layer") aufgebracht. Um den Übertritt von Löchern aus der Anode in die Lochleitungsschicht zu erleichtern, d.h. die Injektionsbarriere für Löcher zu erniedrigen, wird oft zunächst eine Zwischenschicht aus PEDOT/PSS (Poly(3,4-ethylendioxythiophen) dotiert mit Polystyrolsulfonat) auf die Anode aufgebracht, ehe dann die Lochtransportschicht aufgebracht wird. Auf die Lochtransportschicht folgt dann eine Emitterschicht (EL = "emitter layer"), welche einen Farbstoff in einem Anteil von beispielsweise 5 bis 10 Gew.-% enthält oder aus diesem aufgebaut ist. Auf diese kann dann eine Elektronenleitungsschicht (ETL = "electron transport layer") aufgebracht werden. Zum Abschluss wird im Hochvakuum eine Kathode aufgedampft, welche aus einem Metall oder einer Legierung mit geringer Elektronenaustrittsarbeit besteht, wie zum Beispiel Calcium, Aluminium, Barium, Ruthenium, Magnesium-Silber-Legierung. Als Schutzschicht und zur Verringerung der Injektionsbarriere für Elektronen kann zwischen Kathode und ETL noch eine sehr dünne Schicht aus Lithiumfluorid, Cäsiumfluorid oder Silber aufgedampft werden. Der Aufbau von OLEDs ist also relativ komplex und erfordert mehrere Arbeitsschritte. Ferner sind die verwendeten Materialien empfindlich gegenüber Feuchtigkeit und Sauerstoff, sodass der Aufbau verkapselt werden muss, um seine Funktionsfähigkeit der OLED über einen längeren Zeitraum zu gewährleisten.

Von der Kathode werden Elektronen und von der Anode Löcher als Ladungsträger in den Schichtaufbau injiziert. Elektronen und Löcher driften aufeinander zu und treffen sich in der Emitterschicht um einen gebundenen Zustand zu bilden, welcher als Exciton bezeichnet wird. Bei der Rekombination der Ladungsträger werden Singulett- und Triplett-Excitonen im Verhältnis 1 : 3 gebildet. Durch den Zerfall des Excitons wird die Energie für die Anregung des Farbstoffmoleküls bereitgestellt. Der angeregte Zustand kann dann wieder in den Grundzustand übergehen und dabei ein Photon aussenden. Bei einer Emission aus dem Singulett-Zustand, die als Fluoreszenz bezeichnet wird, führen nur maximal 25 % der erzeugten Excitonen zur Emission, während die aus dem Triplett-Zustand erfolgenden strahlungslosen Übergänge in Form von Wärme verloren gehen. Der Übergang aus dem Triplett Zustand $T_1$ in den Singulett-Zustand $S_0$ ist stark Spinverboten und steht daher für eine Emission von Licht nicht zur Verfügung.

Bei einer Triplett-Emission, die als Phosphoreszenz bezeichnet wird, können durch Triplett-Harvesting theoretisch sämtliche Excitonen genutzt und als Licht emittiert werden. Dabei wird der mitangeregte und energetisch über dem Triplett-Zustand liegende Singulett-Zustand durch Inter-System-Crossing vollständig in den Triplett-Zustand relaxiert.

Als Triplett-Emitter werden meist Übergangsmetallkomplexverbindungen eingesetzt, in denen das Metall aus der dritten Periode der Übergangsmetalle gewählt wird, beispielsweise Iridium, Platin oder auch Gold. Durch die hohe Spin-Bahn-Kopplung der Edelmetall-Zentralionen wird der für optische Übergänge strikt verbotene Triplett-Singulett-Übergang erlaubt und die für eine Anwendung in OLEDs geeignete Emissionslebensdauer von wenigen $\mu$s erreicht. Bei wachsenden Stromdichten und der dadurch resultierenden Besetzung eines Großteils oder aller Triplettzustände $T_1$ der Emittermoleküle ergeben sich jedoch Sättigungseffekte und in der Folge können Ladungsträgerströme nicht mehr vollständig zur Besetzung angeregter Zustände genutzt werden, d.h. es ergeben sich ohmsche Verluste und die Effizienz des Emitters sinkt ("Roll-off"-Verhalten).

Singulett-Emitter weisen eine deutlich geringere Emissionslebensdauer im Bereich von Nanosekunden auf, sodass Roll-off-Effekte in deutlich geringerem Maß bzw. nicht auftreten. Die Effizienz der Emitter bzw. die Quantenausbeute lässt sich steigern, indem auch die Triplett-Zustände für die Emission von Licht genutzt werden. Dazu muss der Energieunterschied zwischen dem höchsten besetzten Triplett-Zustand $T_1$ und dem untersten angeregten Singulett-Zustand $S_1$ allerdings klein sein, sodass bei Raumtemperatur eine thermische Rückbesetzung des Singulett-Zustandes $S_1$ aus dem Triplett-Zustand $T_1$ erfolgen kann. Ferner muss eine starke Spin-Bahn-Kopplung ermöglicht werden, sodass durch Inter-System-Crossing der an sich spin-verbotene Übergang $T_1 \rightarrow S_1$ möglich wird. Die Emissionslebensdauer für diesen Übergang sollte im Bereich von weniger als 1 $\mu$s liegen, beispielsweise bei etwa 100 bis 600 ns.

Beim Singulett-Harvesting erfolgt also wie beim Triplett-Harvesting eine Besetzung des niedrigsten angeregten Triplett-Zustands. Die Emission erfolgt jedoch nicht aus dem tiefsten Triplett-Zustand $T_1$, sondern über eine thermische Rückbesetzung aus dem niedrigsten angeregten Singulett-Zustand $S_1$, sodass die sonst verlorene Anregungsenergie für den Triplett-Zustand nahezu vollständig für die Lichtemission zur Verfügung steht.

Dieser Vorgang wird als thermisch aktivierte verzögerte Fluoreszenz (TADF = "thermally activated delayed fluorescence") bezeichnet und wird beispielsweise von B. H. Uoyama et al., Nature 2012, Vol. 492, 234 beschrieben. Um diesen Prozess zu ermöglichen, ist im Emitter ein vergleichsweise kleiner Singulett-Triplett-Abstand $\Delta E(S_1 - T_1)$ von zum Beispiel weniger als etwa 2000 $cm^{-1}$ nötig. Um den an sich spin-verbotenen Übergang $T_1 \rightarrow S_1$ zu öffnen, kann neben dem Emitter eine weitere Verbindung in der Matrix vorgesehen werden, die eine starke Spin-Bahn-Kopplung aufweist, sodass über die räumliche Nähe und die damit mögliche Wechselwirkung zwischen den Molekülen ein Inter-System-Crossing ermöglicht wird, oder die Spin-Bahn-Kopplung wird über ein im Emitter enthaltenes Metallatom erzeugt.

Als Emitter eignen sich vor allem Moleküle, die einen hohen Charge-Transfer-Charakter zeigen, wie z.B. Kupferverbindungen. Eine stark lumineszierende Verbindung, die eine thermisch aktivierte verzögerte Fluoreszenz zeigen, muss also so gestaltet werden, dass sie einen sehr kleinen Abstand $\Delta E(S_1 - T_1)$ bei relativ kurzen Abklingraten von > $10^6$ $s^{-1}$ aufweist, sodass konkurrierende Abklingwege, bei welchen keine Emission von Licht erfolgt, zurücktreten.

Als weiteres lichtemittierendes elektronisches Bauelement wurden organische lichtemittierende elektrochemische Zellen (OLEC = "organic light emitting electrochemical cell, auch LEC oder LEEC) entwickelt. OLECs wurden erstmals von Ouibing Pei et al., Science, 1995, 296, 1086 - 1088 beschrieben, wo auch die grundlegenden Prinzipien erläutert sind.

OLECs zeigen im Vergleich zu OLEDs einen einfacheren Aufbau und lassen sich auch einfacher herstellen. So können OLECs im Vergleich zu OLEDs eine geringere Anzahl von Schichten aufweisen. Ferner kann die aktive Schicht bei OLECs dicker ausgeführt werden, sodass einfachere Verfahren zur Herstellung der aktiven, lichtemittierenden Schicht eingesetzt werden können. Die aktive Licht emittierende Schicht kann bei OLECs in einer Stärke von mehreren Mikrometern bis hin zu mehreren 10 Mikrometern ausgeführt werden. Zum Aufbringen der aktiven Schicht können daher Verfahren wie Ink-jet-printing, Screen-printing oder Sprühbeschichten eingesetzt werden, die sich auch für eine kostengünstige Massenproduktion eignen. OLECs zeigen eine im Vergleich zu OLEDs geringere Empfindlichkeit gegenüber Unregelmäßigkeiten der Substratoberfläche sowie gegenüber Defekten in der aktiven Schicht. OLECs sollten daher eine bessere Eignung zur Herstellung großflächiger lichtemittierender Vorrichtungen aufweisen.

Eine OLEC umfasst zwei Elektroden sowie eine zwischen Kathode und Anode angeordnete aktive Schicht. Die aktive Schicht umfasst einen Licht emittierenden organischen Halbleiter sowie einen Elektrolyt, welcher bewegliche Ionen zur Verfügung stellt. Um einen Lichtaustritt zu ermöglichen, sollte zumindest eine der Elektroden transparent sein.

Als Licht emittierende organische Halbleiter können konjugierte Copolymere oder ionische Übergangsmetallkomplexe eingesetzt werden, wie sie beispielsweise auch in OLEDs verwendet werden. Beispielhafte Übergangsmetallkomplexverbindungen sind Tris(2-phenylpyridin)iridium ($Ir(ppy)_3$) oder Tris(8-hydroxychinolin)aluminium ($Alq_3$). Kleine Moleküle bieten den Vorteil, dass sie sich leichter verarbeiten lassen, da sie leichter in einem geeigneten Lösungsmittel gelöst werden können. Allerdings kann bei der Verarbeitung dieser Lösungen die Schwierigkeit schlechter Filmbildungseigenschaften auftreten.

Die Fähigkeit des organischen Halbleiters, Licht zu emittieren, wird von der Energie des höchsten besetzten Molekülorbitals (HOMO), des niedrigsten freien Molekülorbital (LUMO) sowie deren relative Lage bestimmt. Bei organischen Halbleitern lassen sich HOMO und LUMO jedoch in ihrer Energie einstellen, indem am Molekül Seitenketten eingeführt werden oder Copolymere aus verschiedenen organischen Halbleitern hergestellt werden, sodass in der Copolymerkette verschiedene organische Halbleiter vorhanden sind. Auf diese Weise lässt sich auch die Löslichkeit des organischen Halbleiters sowie dessen Filmbildungseigenschaften beeinflussen. Die Wechselwirkung zwischen den Orbitalen, durch welche die Lage der Energiezustände bestimmt wird, wird jedoch auch durch die Geometrie des Polymers sowie die relative Lage zu anderen Molekülen beeinflusst. Bei Filmen, die aus Lösungen hergestellt werden, kann daher ein Wechsel des Lösungsmittels die Lage des HOMO und des LUMO beeinflussen, sodass die Emission eines organischen, Licht-emittierenden Bauteils wegen des amorphen Charakters des Films ein relativ breites Spektrum aufweist.

Die meisten Metalle weisen eine relativ hohe Austrittsarbeit auf, weshalb an den Elektroden ein erheblicher Energieaufwand besteht, um Elektronen aus dem Elektrodenmaterial in den organischen Halbleiter zu injizieren. Bei Verwendung von Alkali- oder Erdalkalimetallen weisen diese Metalle zwar eine niedrige Austrittsarbeit auf, sodass die

Energiedifferenz zwischen der Kathode und dem LUMO des organischen Halbleiters verringert wird. Diese Metalle sind gegenüber Sauerstoff und Wasser jedoch sehr reaktiv, sodass die Herstellung der elektronischen Bauteile aufwändig ist.

Bei organischen lichtemittierenden elektrochemischen Zellen werden bewegliche Ionen genutzt, um den Ladungsübertritt von der Elektrode in die Aktivschicht zu ermöglichen. Wird zwischen Kathode und Anode eine Spannung angelegt, reichern sich an der Kathode positive Ionen und an der Anode negative Ionen an, sodass sich eine elektrische Doppelschicht ausbildet. Die elektrischen Doppelschichten sind sehr dünn, wodurch sich unabhängig von der Schichtdicke der Aktivschicht an der Grenzfläche zur Elektrode ein starker elektrischer Feldgradient aufbaut. Besteht zwischen den Elektroden eine ausreichend große Potentialdifferenz, ermöglicht die elektrische Doppelschicht eine effiziente Injektion von Ladungsträgern in das HOMO bzw. LUMO des organischen Halbleiters. Die Injektion von Ladungsträgern wird durch eine gegenläufige Bewegung geladener Ionen kompensiert. Die Injektion von Elektronen an der Kathode bewirkt daher eine Anreicherung positiver Ionen und verursacht damit eine n-Dotierung. Die Extraktion von Elektronen an der Anode, bzw. die Injektion von Löchern an der Anode wird entsprechend von negativ geladenen Ionen kompensiert und bewirkt eine p-Dotierung. Durch die elektrochemische Dotierung wird der Transport von Elektronen bzw. Löchern im organischen Halbleiter erleichtert. Auch bei dickeren Aktivschichten, die einen größeren Elektrodenabstand bewirken, kann daher bei niedriger Potentialdifferenz ein wirksamer Ladungstransport bewirkt werden.

Die elektrochemisch dotierten Bereiche wachsen in Richtung aufeinander zu bis sie schließlich aufeinandertreffen und in einer sehr dünnen undotierten Schicht eine pn-Rekombination bewirkt wird. Der Mechanismus des Ladungstransports in OLECs und OLEDs unterscheidet sich jedoch maßgeblich. Während die Ladungen in OLECs mit Hilfe von mobilen Ionen transportiert werden, erfolgt der Ladungstransport in OLEDs durch Hopping von Elektronen/Löchern von mehr oder weniger stationären Molekülen. Ferner enthalten OLEDs oft weitere Schichten (bspw. Elektronen- und Lochtransportschichten) mit unterschiedlichen Materialien. Die OLEC erfordert bei der Herstellung hingegen nur die Bereitstellung einer einzelnen homogenen Aktivschicht, da sich die Schichten für den Elektronen- bzw. Lochtransport nach Anlegen einer Potentialdifferenz zwischen den Elektroden von selbst in der Aktivschicht ausbilden.

Im Vergleich zu OLEDs hängt daher die Funktion der OLEC nicht von der Austrittsarbeit der Elektroden ab. Somit können beide Elektroden aus demselben Material hergestellt werden. Es ist somit auch möglich, eine komplett metallfreie OLEC herzustellen.

OLEDs sind Dioden mit einer Vorwärts- und einer Rückwärtsrichtung beim Ladungstransport, d.h. die Strom-Spannungskurven sind unsymmetrisch. OLECs sind im Wesentlichen eine elektrolytische Zelle. Nach Anlegen einer Potentialdifferenz wird der Elektrolyt an der Anode oxidiert und an der Kathode reduziert.

OLECs werden typischerweise mit einer einzigen Lösung hergestellt, die Licht emittierende und Ladung transportierende konjugierte Polymere enthält, wie beispielsweise Polyphenylen-vinylen-polymere, Polythiophen-Polymere oder Polyfluoren-Polymere, sowie ein Elektrolytsystem, das bewegliche ionische Dotiermittel, wie beispielsweise Lithiumtriflate, sowie den Elektrolyten bildende Verbindungen enthält, wie beispielsweise Polyethylenoxid.

Licht emittierende elektrochemische Zellen sind beispielsweise aus der WO 2013/173845 bekannt.

EP 2733188 offenbart Zusammensetzungen für organische Elektrolumineszenz-Vorrichtungen wie OLEDs oder OLECs, wobei die Zusammensetzungen eine metallorganische Verbindung als lumineszierende Verbindung und eine ionische Verbindung als Hostmaterial umfassen.

WO 2014/094965 offenbart auch Zusammensetzungen für organische Elektrolumineszenz-Vorrichtungen, wobei die Zusammensetzungen lumineszierende Verbindungen und Hostmaterialien umfassen.

Verwendet man als Farbstoff einen Singulett-Emitter, geht analog zu den Prozessen, wie sie oben für OLEDs beschrieben wurden, die bei Triplett-Übergängen freiwerdende Energie in Form von Wärme verloren. Da nur etwa 25 % der Rekombinationen von Ladungsträgern zu Singulett-Excitonen führen, bedeutet dies dass 75 % aller Ladungsträger, die in die aktive Schicht injiziert werden, für die Lichterzeugung verloren gehen. Die Effizienz in Bezug auf die Lichtausbeute ist bei derartigen LECs also nicht zufriedenstellend. Im Stand der Technik ist bekannt, dass OLEDs den OLECs hinsichtlich Lebensdauer und Effizienz deutlich überlegen sind.

Der Erfindung lag daher die Aufgabe zu Grunde, organische lichtemittierende elektrochemische Zellen (OLECs) zur Verfügung zu stellen, welche mit der eingesetzten elektrischen Energie eine hohe Lichtausbeute erzielen und die aus dem Stand der Technik bekannten Nachteile überwinden.

Diese Aufgabe wird mit einer Zusammensetzung mit den Merkmalen des Anspruchs 1 gelöst. Vorteilhafte Ausführungsformen sind Gegenstand der abhängigen Patentansprüche.

Erfindungsgemäß wird eine Zusammensetzung zur Verfügung gestellt, die eine organische lumineszierende Verbindung sowie eine ionische Verbindung sowie zumindest ein Hostmaterial enthält, wobei die organische lumineszierende Verbindung einen Energieabstand $\Delta E$ zwischen dem niedrigsten Triplett-Zustand $T_1$ und dem ersten angeregten Singulett-Zustand $S_1$ von kleiner oder gleich 0,15 eV aufweist,
wobei die organische lumineszierende Verbindung eine metallfreie organische Verbindung ist, die aus aromatischen Verbindungen ausgewählt ist, die sowohl Donor- als auch Akzeptorsubstituenten aufweisen, wobei die Akzeptorgruppe ausgewählt ist aus der Gruppe bestehend aus CN, $CF_3$, elektronenarmen Heteroarylgruppen und die Donorgruppe ausgewählt ist aus Diarylaminogruppen, Diheteroarylaminogruppen, Carbazolgruppen;

wobei die ionische Verbindung ein Elektrolyt, eine ionische Flüssigkeit oder ein ionischer Übergangsmetallkomplex (iTMC) ist; und

wobei das Hostmaterial einen niedrigsten Triplett-Zustand $T_1^H$ aufweist, der eine Energie aufweist, welche höher liegt als der niedrigsten Triplett-Zustand $T_1$ der neutralen organischen lumineszierenden Verbindung.

Mit der erfindungsgemäßen Zusammensetzung kann in OLECs eine aktive Schicht bereitgestellt werden, die eine hohe Lichtausbeute bei kurzen Abklingzeiten aufweist, sodass OLECs mit einer hohen Lichtstärke bei niedrigem Energieverbrauch zur Verfügung gestellt werden können. Durch den geringen Energieabstand $\Delta E(S_1 - T_1)$ kann eine thermische Rückbesetzung des Singulett-Zustandes erreicht werden, von welchem dann ein Übergang in den Grundzustand $S_0$ unter Emission von Licht erfolgt. Dadurch kann eine hohe Quanteneffizienz erreicht werden, da sowohl die $S_1$- als auch die $T_1$-Zustände für die Emission von Licht genutzt werden. Durch die beim Anlegen einer Potentialdifferenz zwischen Anode und Kathode erfolgende Ausbildung einer elektrischen Doppelschicht und der nachfolgenden Dotierung der Aktivschicht durch injizierte Elektronen bzw. Löcher wird eine Öffnung des Übergangs $T_1 \rightarrow S_1$ bei relativ kurzer Emissionslebenszeit möglich, sodass Roll-off Effekte zurückgedrängt werden können.

Als, vorzugsweise neutrale, organische lumineszierende Verbindung können beispielsweise Verbindungen eingesetzt werden, wie sie aus der Anwendung in OLEDs beschrieben sind.

Bevorzugt weist das $S_1$-Niveau der organischen lumineszierenden Verbindung eine höhere Energie auf als das $T_1$-Niveau.

Die Energie des niedrigsten angeregten Singulettzustands ($S_1$) und des niedrigsten angeregten Triplettzustands ($T_1$) werden durch quantenchemische Rechnung bestimmt. Wie diese Bestimmung im Sinne der vorliegenden Erfindung durchgeführt wird, ist im Beispielteil ausführlich allgemein beschrieben.

Eine lumineszierende Verbindung im Sinne der vorliegenden Erfindung ist eine Verbindung, die in der Lage ist, unter optischer Anregung in einer Umgebung, wie sie in der OLEC vorliegt, bei Raumtemperatur Licht zu emittieren. Dabei weist die Verbindung bevorzugt eine Lumineszenzquanteneffizienz von mindestens 40% auf, besonders bevorzugt von mindestens 50%, ganz besonders bevorzugt von mindestens 60% und insbesondere bevorzugt von mindestens 70%. Dabei wird die Lumineszenzquanteneffizienz bestimmt in einer Schicht in Mischung mit dem Matrixmaterial, wie sie in der OLEC verwendet werden soll. Wie die Bestimmung der Lumineszenzquantenausbeute im Sinne der vorliegenden Erfindung durchgeführt wird, ist im Beispielteil ausführlich allgemein beschrieben.

Gemäß einer Ausführungsform ist der Abstand $S_1 - T_1$ zwischen dem niedrigsten Triplett-Zustand $T_1$ und dem ersten angeregten Singulett-Zustand $S_1$ in der Weise gewählt, dass $\Delta E = E(S_1)-E(T_1)$ kleiner oder gleich 0,12 eV, weiter bevorzugt kleiner oder gleich 0.10 eV, gemäß einer weiteren Ausführungsform kleiner oder gleich 0,05 eV, und gemäß noch einer weiteren Ausführungsform kleiner oder gleich 0,025 eV ist. Ein geringerer Abstand $S_1 - T_1$ ermöglicht eine effiziente thermische Rückbesetzung des niedrigsten angeregten Singulett-Zustandes $S_1$ aus dem niedrigsten angeregten Triplett-Zustand $T_1$ mit einer raschen Emission beim Übergang zum Grundzustand $S_0$.

Gemäß der Erfindung ist die neutrale organische lumineszierende Verbindung eine metallfreie organische Verbindung. Metallfreie lumineszierende organische Verbindungen lassen sich wegen des Verzichts auf teure Edelmetalle, wie Iridium oder Platin, kostengünstig bereitstellen.

Gemäß einer Ausführungsform ist die neutrale organische lumineszierende Verbindung eine kohlenstoffhaltige Verbindung, welche aus den Elementen C, H, D, B, Si, N, P, O, S, F, Cl, Br und/oder I aufgebaut ist.

Gemäß einer weiteren Ausführungsform ist die neutrale organische lumineszierende Verbindung eine kohlenstoffhaltige Verbindung, welche aus Elementen aufgebaut ist, die aus der Gruppe ausgewählt sind, welche aus C, H, N und O gebildet ist.

Gemäß der Erfindung ist die neutrale organische lumineszierende Verbindung eine aromatische Verbindung, die sowohl Donor- als auch Akzeptorsubstiutenten aufweist.

Geeignet können alle neutralen organischen lumineszierenden Verbindungen verwendet werden, wie sie beispielsweise aus anderen Anwendung bekannt sind.

Bei der neutralen organischen lumineszierenden Verbindung handelt es sich bevorzugt um eine aromatische Verbindung, die sowohl Donor- als auch Akzeptorsubstituenten aufweist, wobei bevorzugt ist, wenn das LUMO und das HOMO der Verbindung räumlich nur schwach überlappen.

Bevorzugt weist die neutrale organische lumineszierende Verbindung eine geringe räumliche Überlappung $\Lambda$ der Molekülorbitale auf, die bei bestimmten elektronischen Übergängen beteiligt sind (Charge-Transfer-Zustände).

Vorliegend bedeutet eine geringe Überlappung der Molekülorbitale, dass der Wert des Parameters $\Lambda$ 0.3 oder kleiner ist, bevorzugt ist er 0.2 oder kleiner, ganz bevorzugt ist er 0.15 oder kleiner, ganz besonders bevorzugt ist er 0.1 oder kleiner und insbesondere bevorzugt ist er 0.05 oder kleiner. Gemäß einer Ausführungsform ist der Parameter gleich oder größer als 0,001. Die Bestimmung des Parameters $\Lambda$ ist im Beispielteil ausführlich allgemein beschrieben.

Was unter Donor- bzw. Akzeptorsubstituenten verstanden wird, ist dem Fachmann hinlänglich bekannt. Geeignete Donorsubstituenten sind insbesondere Diaryl- bzw. -heteroarylaminogruppen sowie Carbazolgruppen bzw. Carbazolderivate, die jeweils bevorzugt über N an die aromatische Verbindung gebunden sind. Dabei können diese Gruppen auch weiter substituiert sein. Geeignete Akzeptorsubstituenten sind insbesondere Cyanogruppen, aber auch beispielsweise elektronenarme Heteroarylgruppen, die auch weiter substituiert sein können.

Unter der Akzeptorgruppe A (auch Akzeptorsubstituent genannt) wird vorliegend eine Gruppe verstanden, die eine Elektronenakzeptorgruppe darstellt. Was unter einer Akzeptorgruppe verstanden wird, ist dem Fachmann gut bekannt. Es ist bevorzugt, wenn die Akzeptorgruppe einen negativen induktiven Effekt (-I) und/oder einen negativen mesomeren Effekt (-M) aufweist. Die Bestimmung der Parameter mit Hilfe der Hammett-Gleichung ist dem Fachmann auch gut bekannt Geeignete Akzeptorsubstituenten sind insbesondere Cyanogruppen, aber auch $CF_3$ und beispielsweise elektronenarme Heteroarylgruppen, die auch weiter substituiert sein können. Beispiele bevorzugter elektronenarmer Heteroarylgruppen sind ausgewählt aus der Gruppe bestehend aus Triazinen, Pyrimidinen, Phosphinoxiden und Ketonen.

Die Akzeptorgruppe ist gemäß der Erfindung aus der Gruppe bestehend aus CN, $CF_3$, elektronenarmen Heteroarylgruppen ausgewählt.

Unter der Donorgruppe D (auch Donorsubstituent genannt) wird vorliegend eine Gruppe verstanden, die eine Elektronendonorgruppe darstellt. Was unter einer Donorgruppe verstanden wird, ist dem Fachmann gut bekannt. Es ist bevorzugt, wenn die Donorgruppe einen positiven induktiven Effekt (+I) und/oder einen positiven mesomeren Effekt (+M) aufweist. Die Bestimmung der Parameter mit Hilfe der Hammett-Gleichung ist dem Fachmann gut bekannt. Geeignete Donorsubstituenten sind insbesondere Diaryl- bzw. -heteroarylaminogruppen sowie Carbazolgruppen bzw. Carbazolderivate, wie Indenocarbazole oder Indolocarbazole, die jeweils bevorzugt über N an die Brücke V bzw. an die Gruppe A gebunden sind. Dabei können diese Gruppen auch weiter substituiert sein.

Gemäß der Erfindung ist die Donorgruppe ausgewählt aus Diarylaminogruppen, Diheteroarylaminogruppen, Carbazolgruppen.

Beispiele für geeignete Moleküle, die eine thermisch aktivierte verzögerte Fluoreszenz (TADF) zeigen und damit als neutrale organische lumineszierende Verbindung in Betracht kommen, sind die in der folgenden Übersicht aufgeführten Strukturen.

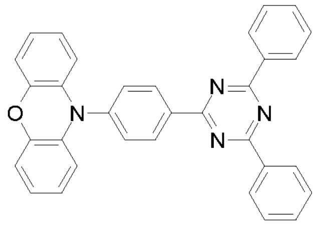

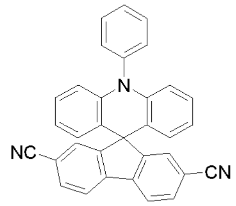

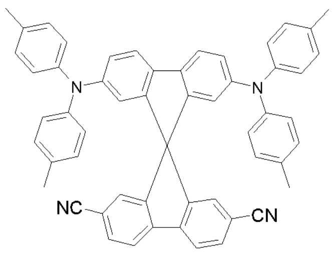

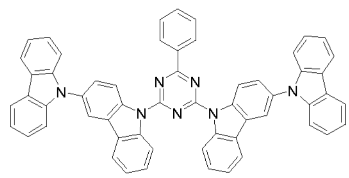

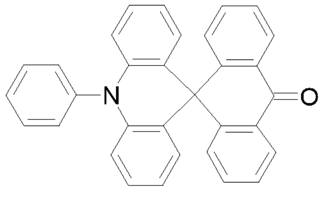

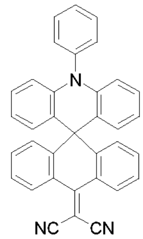

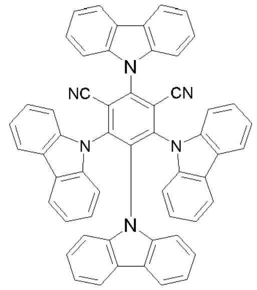

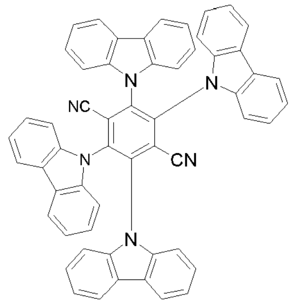

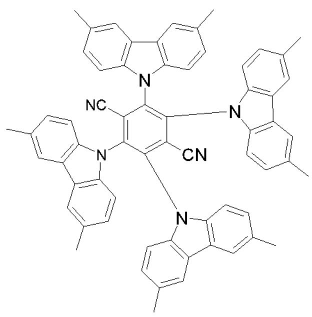

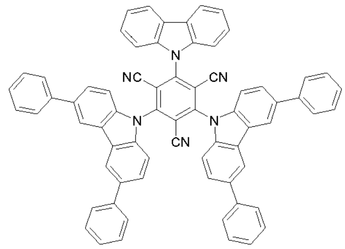

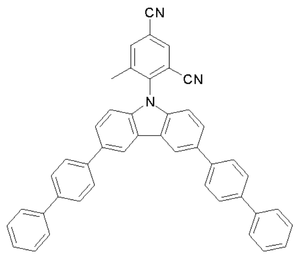

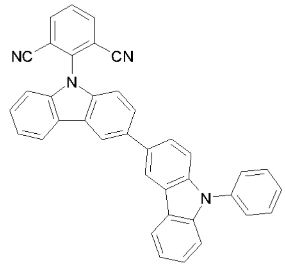

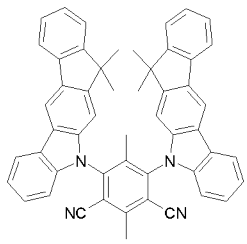

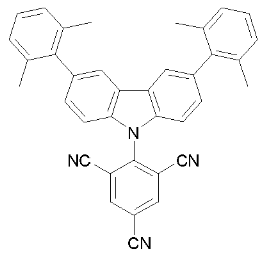

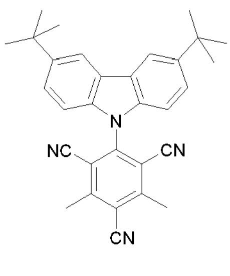

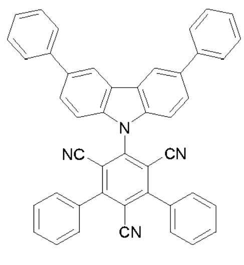

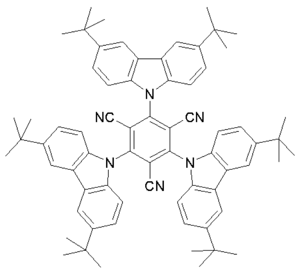

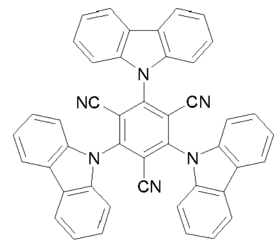

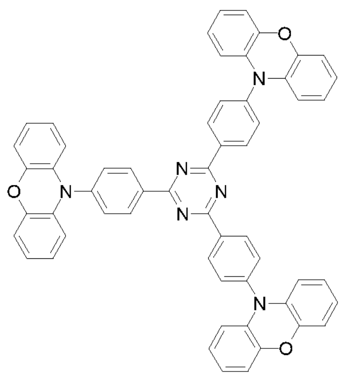

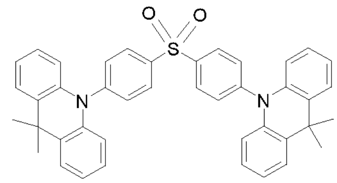

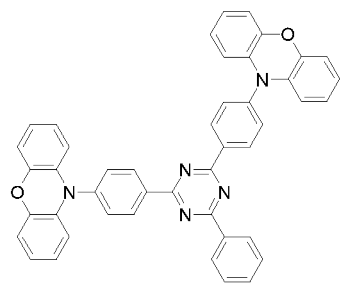

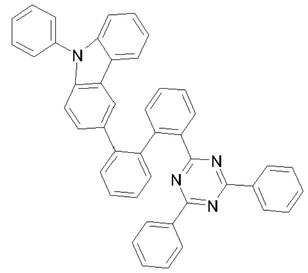

Gemäß einer Ausführungsform ist die neutrale organische elektrolumineszierende Verbindung ausgewählt ist aus der Gruppe von

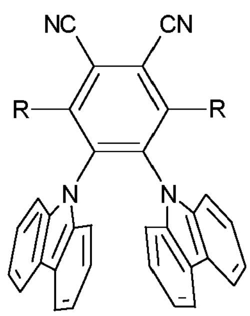
,
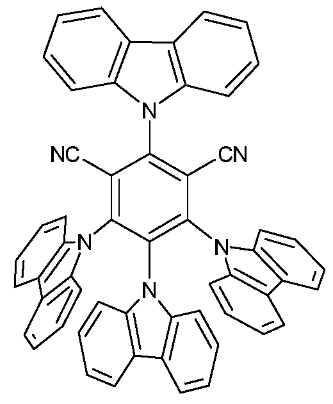
,
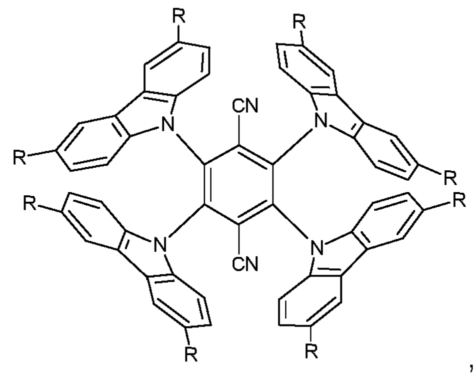
,

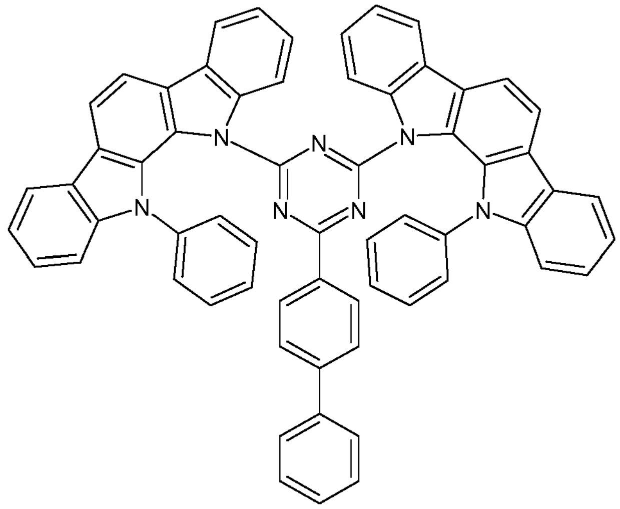

.

R ist dabei für jedes Auftreten unabhängig ausgewählt aus der Gruppe von H, Carbazoyl, Methyl und Phenyl.

Im Stand der Technik sind eine Vielzahl von neutralen organischen lumineszierende Verbindung bekannt und es bereitet dem Fachmann keinerlei Schwierigkeiten die Verbindungen aus dem Stand der Technik auszuwählen (z.B.: Tanaka et al., Chemistry of Materials 25(18), 3766 (2013), Zhang et al., Nature Photonics advance online publication, 1 (2014), doi: 10.1038/nphoton.2014.12, Serevicius et al., Physical Chemistry Chemical Physics 15(38), 15850 (2013), Youn Lee et al., Applied Physics Letters 101(9), 093306 (2012), Nasu et al., ChemComm, 49, 10385 (2013), WO 2013/154064, WO 2013/161437, WO 2013/081088, WO 2013/011954).

Gemäß einer Ausführungsform weist die neutrale organische lumineszierende Verbindung eine kurze Abklingzeit auf, die gemäß einer weiteren Ausführungsform kleiner oder gleich 50 $\mu$s ist. Gemäß einer weiteren Ausführungsform ist die Abklingzeit kleiner oder gleich 10 $\mu$s, gemäß einer weiteren Ausführungszeit kleiner oder gleich 1 $\mu$s und gemäß noch einer weiteren Ausführungsform kleiner oder gleich 600 ns. Gemäß einer Ausführungsform ist die Abklingzeit größer oder gleich 1 ns und gemäß einer weiteren Ausführungsform größer oder gleich 10 ns und gemäß noch einer weiteren Ausführungsform größer oder gleich 100 ns.

Wie die Bestimmung der Abklingzeit im Sinne der vorliegenden Erfindung durchgeführt wird, ist im Beispielteil ausführlich allgemein beschrieben.

Als weiteren wesentlichen Bestandteil enthält die erfindungsgemäße Zusammensetzung eine ionische Verbindung, über welche der Ladungstransport in der OLEC erfolgt.

Was unter ionischen Verbindung zu verstehen ist, ist dem Fachmann hinlänglich bekannt. Dabei wird auf den ionischen Charakter von Salzen abgestellt, die wenigstens aus einem Kation und einem Anion bestehen. Nicht unter den Begriff ionischen Verbindung fallen, beispielsweise, neutrale organische Metallkomplexe, die ein oder mehrere Metallzentren und einen oder mehrere Liganden enthalten. Zwischen den Metallzentren und den Liganden bilden sich kovalente/koordinative/ dative Bindungen aus, die nicht als ionische Bindungen betrachtet werden.

Gemäß der Erfindung ist die ionische Verbindung ein Elektrolyt, eine ionische Flüssigkeit oder ein ionischer Übergangsmetallkomplex (iTMC).

Ein geeignetes iTMC Material wird beispielsweise von Rudmann et al., J. Am. Chem. Soc. 2002, 124, 4918-4921 and Rothe et al., Adv. Func. Mater. 2009, 19, 2038-2044 beschrieben.

Geeignete ionische Verbindungen weisen die allgemeine Formel $K^+A^-$ auf, wobei $K^+$ ein Kation und $A^-$ ein Anion darstellt. Das Kation $K^+$ bzw. das Anion $A^-$ können einfach oder mehrfach geladen sein. Gemäß einer Ausführungsform sind das Kation $K^+$ bzw. das Anion $A^-$ jeweils einfach geladen.

Bevorzugt ist, wenn es sich bei der ionischen Verbindung um ein Salz der allgemeinen Formel $(K^{n+})_m(A^{p-})_q$ handelt, wobei n, m, p und q ganze Zahlen von 1, 2, 3, 4, 5, 6 und 7, bevorzugt von 1, 2 und 3 und ganz bevorzugt von 1 und 2 sind und wobei in jedem Fall gilt, dass n*m gleich p*q ist.

Ferner ist bevorzugt wenn entweder das Kation oder das Anion ein anorganisches Ion darstellt und das jeweils entgegengesetzt geladene Ion ein organisches Ion ist.

Bevorzugt ist die ionische Verbindung im gleichen Lösungsmittel löslich, wie die organische lumineszierende Verbindung, sodass sich diese leicht verarbeiten lässt. Geeignete organische Lösungsmittel sind beispielsweise Toluol, Anisol oder Chloroform.

Unter ionischen Flüssigkeiten werden organische Salze verstanden, deren Ionen durch Ladungsdelokalisierung und sterische Effekte die Bildung eines stabilen Kristallgitters behindern. Bereits geringe thermische Energie genügt daher, um die Gitterenergie zu überwinden und die feste Kristallstruktur aufzubrechen. Ionische Flüssigkeiten sind somit

Salze, die bei Temperaturen unter 100 °C flüssig sind, ohne dass das Salz dabei in einem Lösungsmittel, wie Wasser, gelöst ist.

Gemäß einer Ausführungsform ist das ionische Material bei Raumtemperatur (20 °C) fest und erweicht gemäß einer weiteren Ausführungsform in einem Bereich von 30 bis 37 °C. Gemäß einer Ausführungsform ist die ionische Verbindung bei einer Temperatur von weniger als 100 °C, gemäß einer weiteren Ausführungsform bei einer Temperatur von weniger als 80 °C, und gemäß einer weiteren Ausführungsform bei einer Temperatur von weniger als 50 °C vollständig geschmolzen.

Das Kation der ionischen Verbindung kann organischer oder anorganischer Natur sein. Bevorzugte anorganische Kationen sind solche aus der Gruppe der Alkali- und Erdalkalimetallkationen, bevorzugt sind dabei Kationen aus der Gruppe der Alkalimetalle, insbesondere Kationen von Natrium (Na+), Lithium ($Li^+$) und Kalium ($K^+$). Am meisten bevorzugt ist dabei $Li^+$.

Geeignete anorganische Kationen $K^+$ können ausgewählt werden aus der Gruppe von Lithium-, Kalium- Natrium-, Ammonium-, Phosphonium-, Thiouronium- und Guanidiniumsalzen.

Geeignete Kationen sind in den folgenden Formeln dargestellt:

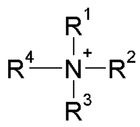

Formel (1)

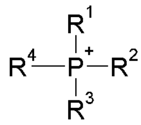

Formel (2)

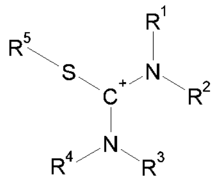

Formel (3)

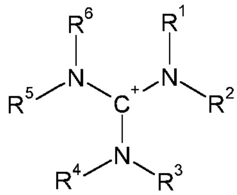

Formel (4)

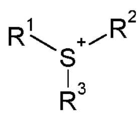

Formel (5)

Darin bedeuten $R^1$ bis $R^6$, jeweils unabhängig voneinander, einen linearen oder verzweigten Alkylrest mit 1 bis 20 Kohlenstoffatomen, einen linearen oder verzweigten Alkenylrest mit 2 bis 20 Kohlenstoffatomen und einer oder mehreren, gemäß einer Ausführungsform zwischen 1 und 4, nicht-konjugierten Doppelbindungen, einen linearen oder verzweigten Alkinylrest mit 2 bis 20 Kohlenstoffatomen und einer oder mehreren, gemäß einer Ausführungsform zwischen 1 und 4, nicht-konjugierten Dreifachbindungen, einen ungesättigten, teilweise gesättigten oder vollständig gesättigten Cycloalkylrest mit 3 bis 7 Kohlenstoffatomen, der auch einfach oder mehrfach mit einer Alkylgruppe mit 1 bis 6 Kohlenstoffatomen substituiert sein kann, wobei auch einer oder mehrere Substituenten R einfach, mehrfach oder vollständig mit Halogenatomen, insbesondere F und/oder Cl, oder einfach oder mehrfach mit -OR', -CN, -C(O)OH, $-C(O)NR'_2$, $-SO_2NR'_2$, $-SO_2OH$, $-SO_2X$, $-NO_2$, substituiert sein können, wobei weiterhin ein oder zwei nicht benachbarte oder nicht in $\alpha$-Stellung stehende Kohlenstoffatome durch eine Gruppe ersetzt sein können, die ausgewählt ist aus der Gruppe von -O-, -S-, -S(O)-, $-SO_2-$, $-N^+R'_2$, -C(O)NR'-, $-SO_2NR'-$, sowie -P(O)R'-, wobei R'für Wasserstoff, eine unsubstituierte oder ganz oder teilweise durch F substituierte C1 bis C6 Alkylgruppe oder eine C3 bis C7-Cycloalkylgruppe, oder eine unsubstituierte oder substituierte Phenylgruppe und X für ein Halogenatom steht.

Bevorzugte Kationen sind aus der Gruppe der Sulfate und Sulfonate, insbesondere aus der Gruppe der Sulfonate. Ganz bevorzugt sind dabei alkylierte Sulfate und Sulfonate und besonders bevorzugt sind alkylierte Sulfonate. Ganz besonders bevorzugte Kationen sind dabei halogenierte Alkylsulafate und halogenierte Alkylsulfonate, wobei halogenierte Alkylsulfonate insbesondere bevorzugt sind. Ein besonders bevorzugtes Beispiel für ein halogeniertes Alkylsulfonat stellt $CF_3SO_3^-$ dar.

In der Formel (1) kann $R^1$ bis $R^4$ für ein Wasserstoffatom stehen, wobei zumindest einer der Gruppen $R^1$ bis $R^4$ kein Wasserstoffatom ist. In Formel (2) können $R^1$ bis $R^4$ H oder $NR_2$' bedeuten, wobei R' wie oben definiert ist. In Formel (3) können $R^1$ bis $R^5$ Wasserstoff bedeuten. In Formel (4) können $R^1$ bis $R^6$, jeweils unabhängig voneinander, H, CN und $NR'_2$ bedeuten, wobei R' die oben angegebene Bedeutung aufweist.

Weitere geeignete heterozyklische Kationen sind im Folgenden dargestellt:

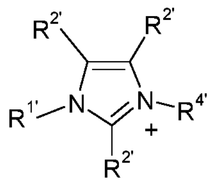
Formel (6)

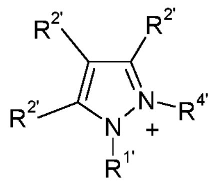
Formel (7)

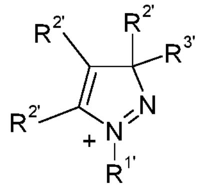
Formel (8)

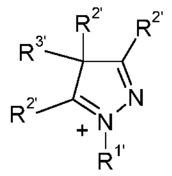
Formel (9)

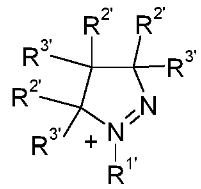
Formel (10)

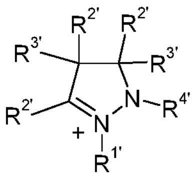
Formel (11)

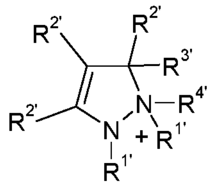
Formel (12)

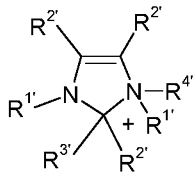
Formel (13)

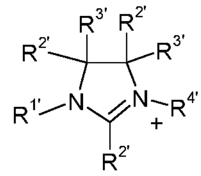
Formel (14)

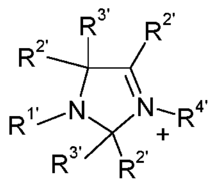
Formel (15)

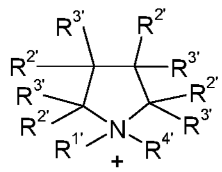
Formel (16)

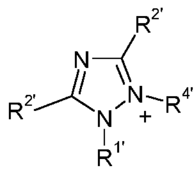
Formel (17)

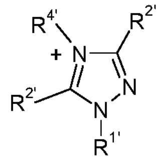
Formel (18)

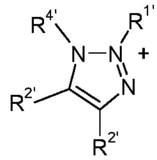
Formel (19)

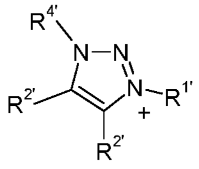
Formel (20)

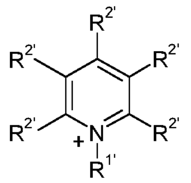

Formel (21)

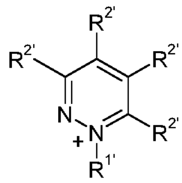

Formel (22)

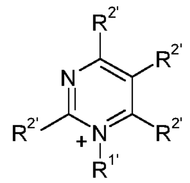

Formel (23)

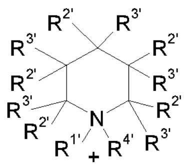

Formel (24)

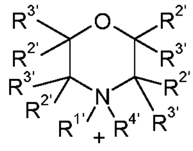

Formel (25)

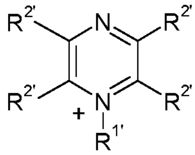

Formel (26)

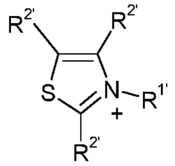

Formel (27)

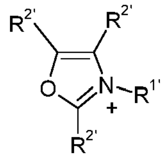

Formel (28)

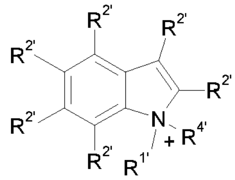

Formel (29)

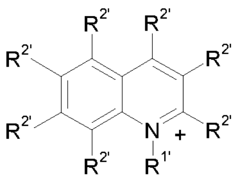

Formel (30)

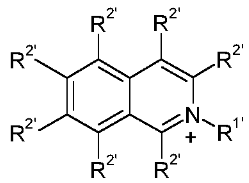

Formel (31)

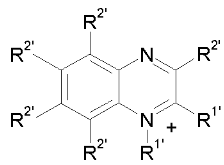

Formel (32)

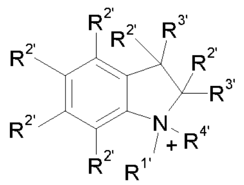

Formel (33)

Dabei sind die Substituenten $R^{1'}$ bis $R^{4'}$, jeweils unabhängig voneinander, ausgewählt aus H, CN, linearen oder verzweigten Alkylketten mit 1 bis 20 Kohlenstoffatomen, linearen oder verzweigten Alkenylresten mit 2 bis 20 Kohlenstoffatomen und einer oder mehreren, gemäß einer Ausführungsform zwischen 1 und 4, nicht-konjugierten Doppelbindungen, linearen oder verzweigten Alkinylresten mit 2 bis 20 Kohlenstoffatomen und einer oder mehreren, gemäß einer Ausführungsform zwischen 1 und 4, nicht-konjugierten Dreifachbindungen, gesättigten sowie teilweise oder vollständig ungesättigte Cycloalkylreste mit 3 bis 7 Kohlenstoffatomen, welche einfach, mehrfach oder vollständig substituiert sein können mit Alkylresten mit 1 bis 6 Kohlenstoffatomen, gesättigten sowie teilweise oder vollständig ungesättigten Heteroarylresten, Heteroaryl-$C_1$-$C_6$-alkylresten, oder Alkyl-$C_1$-$C_6$-alkylresten, wobei die Substituenten $R^{1'}$, $R^{2'}$, $R^{3'}$ und/oder $R^{4'}$ auch gemeinsam einen Ring ausbilden können, und wobei weiter einer oder mehrere der Reste $R^{1'}$ bis $R^{4'}$ teilweise oder vollständig mit Halogen, insbesondere mit -F und/oder -Cl, und/oder -OR', -CN, -C(O)OH, -C(O)NR'$_2$, -C(O)X, -$SO_2$OH, -$SO_2$X, -$NO_2$ substituiert sein können, wobei die Substituenten $R^{1'}$ und $R^{4'}$ jedoch nicht gleichzeitig mit Halogen substituiert sind, und wobei weiter ein oder zwei Kohlenstoffatome der Substituenten $R^{1'}$ und $R_{2'}$, die nicht benachbart zueinander angeordnet oder an ein Heteroatom gebunden sind durch eine Gruppe substituiert sein können,

die aus der Gruppe von -O-, -S-, -S(O)-, $-SO_2-N^+R'_2-$, -C(O)NR'-, $-SO_2NR'-$, sowie -P(O)R'- ausgewählt ist, und wobei weiter R' die oben angegebene Bedeutung aufweist.

Gemäß einer Ausführungsform ist $R^{2'}$ ausgewählt aus der Gruppe von - OR', $-NR'_2$, -C(O)OH, $-C(O)NR'_2$, $-SO_2NR'_2$, $-SO_2OH$, $-SO_2X$, und $-NO_2$.

Weitere geeignete ionische Verbindungen sind beispielsweise in US 2007/0262694 A1 beschrieben.

Gemäß einer weiteren Ausführungsform umfassen die ionischen Verbindungen ein Kation mit einer Struktur der Formel (34). Derartige ionische Verbindungen umfassen beispielsweise Kationen aus der Gruppe von N,N,N-Trimethylbutylammonium, N-Ethyl-N,N-dimethyl-propylammonium, N-Ethyl-N,N-dimethylbutylammonium, N,N,-Dimethyl-N-propylbutylammonium, N-(2-Methoxyethyl)-N,N-dimethylethylammonium, 1-Ethyl-3-methylimidazolium, 1-Ethyl-2,3-di-methylimidazoliun, 1-Ethyl-3,4-dimethylimidazolium, 1-Ethyl-2,3,4-trimethyl-imidazolium, 1-Ethyl-2,3,5-trimethylimidazolium, N-Methyl-N-propylpyrrolidinium, N-Butyl-N-methylpyrrolidinium, N-sec-Butyl-N-methylpyrrolidinium, N-(2-Methoxyethyl)-N-methylpyrrolidinium, N-(2-Ethoxyethyl)-N-methylpyrrolidinium, N-Methyl-N-propylpiperidinium, N-Butyl-N-methylpipridinium, N-sec-Butyl-N-methylpiperidinium, N-(2-Methoxyethyl)-N-methylpiperidinium und N-(2-Ethoxyethyl)-N-methylpiperidinium.

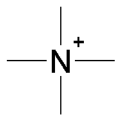

Formel (34)

Bevorzugt wird als Kation N-Methyl-N-propylpiperidinium eingesetzt.

Gemäß einer Ausführungsform werden ionische Verbindungen verwendet, die in üblichen organischen Lösungsmitteln löslich sind, wie beispielsweise Toluol, Anisol, Chloroform. Gemäß einer Ausführungsform ist die ionische Verbindung ausgewählt aus der Gruppe von Methyltrioctylammonium trifluoromethansulfonat (MATS), 1-Methyl-3-octylimidazolium octylsulfat, 1-Butyl-2,3-dimethylimidazolium octylsulfat, 1-Octadecyl-3-methylimidazolium bis(trifluoromethylsulfonyl)imid, 1-Octadecyl-3-methylimidazolium tris(pentafluoroethyl)trifluorophosphat, 1,1-Dipropylpyrrolidimium bis(trifluoromethylsulfonyl)imid, Trihexyl(tetradecyl)-phosphonium bis(1,2-benzy!dio!ato(2-)-O,O')borate, und N,N,N',N',N',N'-Pentamethyl-N'-propylguanidinium trifluormethansulfonat.

Weitere geeignete ionische Verbindungen sind polymere Verbindungen, an welche katonische Gruppen $K^+$ oder anionische Gruppen $A^-$ gebunden sind. Geeignete Anionen der ionischen Verbindung sind beispielsweise $[HSO_4]^-$, $[SO_4]^{2-}$, $[NO_3]^-$, $[BF_4]^-$, $[(R_F)BF_3]^-$, $[(R_F)_2BF_2]^-$, $[(R_F)_3BF]^-$, $[(R_F)_4B]^-$, $[B(CN)_4]^-$, $[PO_4]^{3-}$, $[HPO_4]^{2-}$, $[H_2PO_4]^-$, $[Alkyl\text{-}OPO_3]^{2-}$, $[(Alkyl\text{-}O)_2PO_2]^-$, $[Alkyl\text{-}PO_3]^{2-}$, $[R_FPO_3]^{2-}$, $[(Alkyl)2PO2]^-$, $[(R_F)_2PO_2]^-$, $[RFSO_3]^-$, $[HOSO_2(CF2)_nSO_2O]^-$, $[OSO_2(CF_2)_nSO2O]^{2-}$, $[Alkyl\text{-}SO_3]^-$, $[HOSO_2(CH_2)_nSO_2O]^-$, $[OSO_2(CH_2)_nSO_2O]^{2-}$, $[Alkyl\text{-}OSO_3]^-$, $[Alkyl\text{-}C(O)O]^-$, $[HO(O)C(CH_2)_nC(O)O]^-$, $[R_FC(O)O]^-$, $[HO(O)C(CF_2)_nC(O)O]^-$, $[O(O)C(CF_2)_nC(O)O]^{2-}$, $[(R_FSO_2)_2N]^-$, $[(FSO_2)_2N]^-$, $[((R_F)_2P(O))_2N]^-$, $[(R_FSO_2)_3C]^-$, $[(FSO_2)_3C]^-$, $Cl^-$, Br-, wobei:

n eine ganze Zahl von 1 bis 8 ist,

$R_F$ für einen fluorierten Alkylrest der Formel $(C_mF_{2m-x+1}H_x)$ steht, mit m = 1 bis 12 und x = 0 bis 7, oder für einen teilweise oder vollständig fluorierten Aryl- oder Alkyl-Aryl-Rest. Gemäß einer Ausführungsform ist $R_F$ ausgewählt aus $CF_3$, $C_2F_5$, $C_3F_7$, und $C_4F_9$, und

Alkyl für eine lineare oder verzweigte Alkylgruppe mit 1 bis 20 Kohlenstoffatomen steht, bevorzugt 1 bis 14 Kohlenstoffatomen, weiter bevorzugt 1 bis 4 Kohlenstoffatomen.

Gemäß einer weiteren Ausführungsform ist das Anion $A^-$ ausgewählt aus der Gruppe von $PF_6^-$, $[PF_3(C_2F_5)_3]^-$, $[PF_3(CF_3)_3]^-$, BF4-, $[BF_2(CF_3)_2]^-$, $[BF_2(C_2F_5)_2]^-$, $[BF_3(CF_3)]^-$, $[BF_3(C_2F_5)]^-$, [B(COOCOO)2- (BOB-), $CF_3SO_3^-$ ($Tf^-$), $C_4F_9SO_3$ ($Nf^-$), $[(CF_3SO_2)_2N]^-$($TFSI^-$), $[(C_2F_5SO_2)_2N]^-$ ($BETI^-$), $[(CF_3SO_2)(C_4F_9SO_2)N]^-$, $[(CN)_2N]^-$ ($DCA^-$), $[CF_3SO_2]_3C]^-$, und $[(CN)_3C]^-$.

Gemäß der Erfindung umfasst die Zusammensetzung zumindest ein Hostmaterial. Das Hostmaterial wird auch als Matrixmaterial bezeichnet. Das Hostmaterial weist eine größere Energielücke auf als die zumindest eine neutrale organische lumineszierende Verbindung und wirkt als Elektronen- bzw. Lochleiter bzw. als kombinierter Elektronen-/Lochleiter.

Gemäß einer Ausführungsform überlappt das Absorptionsspektrum der zumindest einen organischen lumineszierenden Verbindung mit dem

Photolumineszenzspektrum des zumindest einen Hostmaterials sodass ein Energieübergang zwischen der zumindest einen organischen lumineszierenden Verbindung und dem zumindest einen Hostmaterial erfolgen kann. An sich können Hostmaterialien verwendet werden, wie sie bei der Anwendung in OLECs bekannt bzw. üblich sind.

Gemäß einer Ausführungsform ist das Hostmaterial ein loch- oder elektronentransportierendes Material.

Gemäß der Erfindung weist das Hostmaterial einen niedrigsten Triplett-Zustand $T_1^H$ auf, der eine Energie aufweist, welche höher liegt als die Energie des niedrigsten Triplett-Zustands $T_1$ der neutralen organischen lumineszierenden Verbindung.

Geeignete Hostmaterial sind beispielsweise ausgewählt aus Anthracenen, Benzanthracenen, Indenofluorenen, Fluorenen, spiro-Bifluorenen, Phenanthrenen, Dehydrophenanthrenen, Dehydrofluorenen, Thiophenen, Triazinen, Carbazolen, Indenocarbazolen, Indolocarbazolen, Pyrimidinen, Lactamen, Benzophenonen, Triarlyaminen, Chinazolinen und Imidazolen.

Gemäß einer Ausführungsform umfasst die Zusammensetzung vier oder weniger Hostmaterialien, gemäß einer weiteren Ausführungsform drei oder weniger Hostmaterialein, und gemäß einer weiteren Ausführungsform ein oder zwei Hostmaterialien.

Besonders bevorzugte Hostmaterialien sind ausgewählt aus der Gruppe der Oligoarylene, wie beispielsweise 2,2',7,7'-tetraphenylspirobifluoren, welches in der EP 676461 beschrieben ist, oder Dinaphthylanthracen. Bevorzugt sind Oligoarylene, welche kondensierte aromatische Gruppen umfassen, wie beispielsweise Phenanthren, Tetracen, Coronen, Chrysen, Fluoren, Spirofluoren, Perylen, Phthaloperylen, Naphthaloperylen, Decacyclen, Rubren, Oligoarylenvinylene, wie beispielsweise 4,4'-bis(2,2-diphenylethenyl)-1,1'-biphenyl (DPVBi) oder 4,4-bis-2,2-diphenylvinyl-1,1-spirobiphenyl (spiro-DPVBi), wie sie in der EP 676461 beschrieben sind.

Weitere geeignete Hostmaterialien sind polypodale Metallkomplexe, wie sie beispielsweise in der WO 2004/081017 beschrieben werden, beispielsweise Metallkomplexe mit 8-Hydroxychinolin, wie Aluminium(III)-tris-(8-hydroxychinolin) ($Alq_3$), oder bis-(2-methyl-8-chinolinolato)-4-(phenylphenolinolato)aluminium, Imidazol-Chelat verbindungen, wie sie in der US 2007/0092753 A1 beschrieben sind, sowie Chinolin-Metallkomplexe, Aminochinoin-Metallkomplexe, Benzochinolin-Metallkomplexe, Loch-transportierende Materialien, wie sie beispielsweise in der WO 2004/058911 beschrieben sind, Elektronentransportierende Materialien, insbesondre Ketone, Phosphinoxide, Sulfoxide, wie sie beispielsweise in der WO 2005/084081 und WO 2005/08408 beschrieben sind, Atropisomere, wie sie in der WO 2006/048268 beschrieben sind, Boronsäurederivate, wie sie beispielsweise in der WO 2006/117052 beschrieben sind, oder Benzanthrazene, wie sie in der DE 102007024850 beschrieben sind.

Weitere geeignete Hostmaterialien sind Oligoarylene, wie Naphthalin, Anthracen, Benzanthracen, und Pyren, sowie Atropisomere dieser Verbindungen, Ketone, Phosphinoxide, und Sulfoxide. Bevorzugt wird das Hostmaterial ausgewählt aus der Klasse der Oligoarylene, insbesondere Naphthalin, Anthracen, Benzanthracen, und Pyren. Unter einer Oligoarylverbindung wird im Sinne dieser Erfindung eine Verbindung verstanden, welche zumindest drei miteinander verbundene Aryl- oder Arylengruppen umfasst.

Weitere geeignete Hostmaterialien sind ausgewählt aus Verbindungen der Formel (35):

$$Ar^4\text{-}(Ar^5)_p\text{-}Ar^6 \qquad \text{Formel (35)}$$

wobei bedeutet:

$Ar^4$, $Ar^5$, $Ar^6$ bei jedem Auftreten gleich oder verschieden eine Aryl- oder Heteroarylgruppe mit 5 bis 30 aromatischen Ringen, die auch ein- oder mehrfach substituiert sein können,

p = 1, 2 oder 3;

wobei die Summe der $\pi$-Elektronen in den Gruppen $Ar^4$, $Ar^5$, $Ar^6$ zumindest 30 beträgt, wenn p = 1, und zumindest 36 beträgt, falls p = 2, und zumindest 42 beträgt, falls p = 3.

Innerhalb der Hostmaterialien der Formel 25 bedeutet $Ar^5$ bevorzugt Anthracen, welches mit einem oder mehreren Resten $R^1$ substituiert sein kann, wobei die Gruppen $Ar^4$ und $Ar^6$ gemäß einer weiteren Ausführungsform an den Positionen 9 und 10 gebunden sind. Besonders bevorzugt ist zumindest eine der Gruppen $Ar^4$ und $Ar^6$ eine kondensierte Arylgruppe, welche bevorzugt ausgewählt ist aus der Gruppe von 1- oder 2-naphthyl, 2-, 3- oder 9-phenanthrenyl oder 2-, 3-, 4-, 5-, 6- oder 7-benzanthracenyl, die jeweils einfach oder mehrfach durch $R^1$ substituiert sein können. $R^1$ ist dabei wie oben definiert.

Geeignete Anthracenverbindungen sind beispielsweise beschrieben in US 2007/0092753 A1 und US 2007/0252517 A1, wie beispielsweise 2-(4-Methylphenyl)-9,10-di-(2-naphthyl)anthracen, 9-(2-Naphthyl)-10-(1,1'-biphenyl)anthracen und 9,10-bis[4-(2,2-Diphenylethenyl)phenyl]anthracen, 9,10-Diphenylanthracen, 9,10-bis(Phenylethynyl)anthracen und 1,4-bis(9'-Ethynylanthracenyl)benzol. Bevorzugt sind auch Hostmaterialien mit zumindest zwei Anthracengruppen (US 2008/0193796 A1), wie beispielsweise 10,10'-bis[1,1',4',1"]Terphenyl-2-yl-9,9'-bisanthracenyl.

Weitere geeignete Hostmaterialien sind Derivate von Arlyaminen, Styryolaminen, Fluorescein, Perynon, Phthaloperynon, Naphthaloperynon, Diphenylbutadien, Tetraphenylbutadien, Cyclopentadiene, Tetraphenylcyclopentadien, Pentaphenylcyclopentadien, Cumarin, Oxadiazol, Bisbenzoxazolin, Oxazon, Pyridin, Pyrazin, Imine, Benzothiazole, Benzoxazole, Benzimidazole (US 2007/0092753 A1), wie beispielsweise 2,2',2"-(1,3,5-phenylen)tris[1-phenyl-1H-benzimidazol], Aldazine, Stilben, Styrylarylen Derivative, wie beispielsweise 9,10-bis[4-(2,2-Diphenylethenyl)phenyl]anthracen, und Distyrylarylenderivative (US 5121029), Diphenylethylen, Vinylanthracen, Diaminocarbazol, Pyran, Thiopyran, Diketopyrrolopyrrol, Polymethin, Mellocyanin, Acridon, Chinacridon, Zimtsäureester sowie Fluoreszenzfarbstoffe.

Gemäß einer bevorzugten Ausführungsform werden Arylamin- sowie Styrylaminderivate als Hostmaterialien verwendet, wie beispielsweise 4,4'-bis[N-(1-naphthyl)-N-(2-naphthyl)amino]biphenyl (TNB).

Als Hostmaterial geeignete Oligoarylene sind beispielsweise beschrieben in US 2003/0027016 A1, US 7326371 B2, US 2006/043858 A, US 7326371 B2, US 2003/0027016 A1, WO 2007/114358, WO 2008/145239, JP 3148176 B2, EP 1009044, US 2004/018383, WO 2005/061656 A1, EP 0681019B1, WO 2004/013073A1, US 5077142, WO 2007/065678, sowie US 2007/0205412 A1.

Als Hostmaterial besonders bevorzugte Verbindungen sind in den folgenden Formeln (36) bis (42) wiedergegeben:

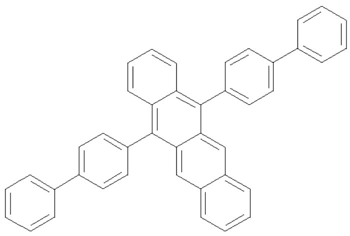

Formel (36)

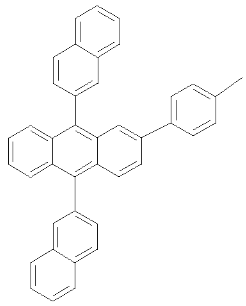

Formel (37)

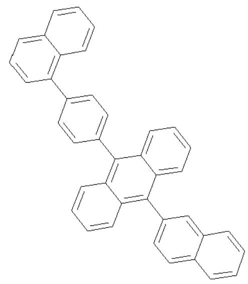

Formel (38)

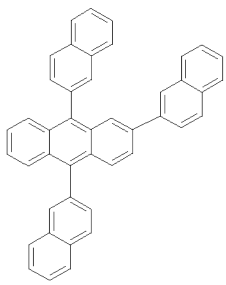

Formel (39)

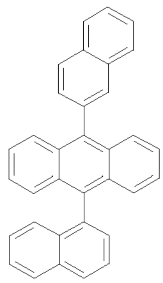

Formel (40)

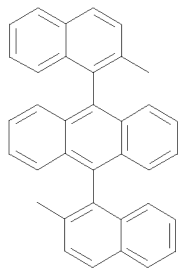

Formel (41)

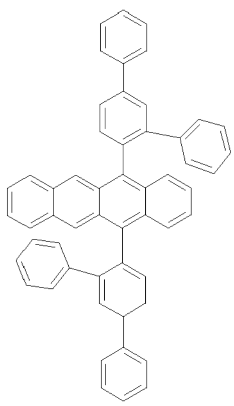

Formel (42)

Weitere geeignete Hostmaterialien sind Spirobifluoren und Derivate hiervon, beispielsweise das in der EP 0676461 beschriebene Spiro-DPVBi oder Indenofluoren, welches in der US 6562485 beschrieben ist.

Gemäß einer Ausführungsform enthält die Zusammensetzung zumindest eine, vorzugsweise neutrale, organische lumineszierende Verbindung, zumindest eine ionische Verbindung und zumindest ein Hostmaterial.

Gemäß einer Ausführungsform kann die Zusammensetzung als weiteren Bestandteil ein ionenleitendes Material umfassen. Geeignete ionenleitende Materialien sind beispielsweise Polyethylenoxid (PEO), Polyethylenoxiddimethylacrylat (PEO-DMA) und Trimethylolpropanethoxylat (TMPE).

Gemäß einer weiteren Ausführungsform kann die Zusammensetzung weitere organische funktionelle Materialien umfassen, wie beispielsweise lochinjizierende Materialien (HIM), lochtransportierende Materialien (HTM), elektronentransportierende Materialien (ETM), elektroneninjizierende Materialien (EIM), oder auch Metallkomplexe.

Der Anteil der, vorzugsweise neutralen, organischen lumineszierenden Verbindung kann gemäß einer Ausführungsform im Bereich von 1 bis 10 Gew.-%, gemäß einer weiteren Ausführungsform im Bereich von 2 bis 7 Gew.-% und gemäß noch einer weiteren Ausführungsform im Bereich von 3 bis 6 Gew.-% gewählt werden.

Der Anteil der ionischen Verbindung wird gemäß einer Ausführungsform größer als 1 Gew.-%, gemäß einer weiteren Ausführungsform größer als 5 Gew.-% und gemäß einer weiteren Ausführungsform größer als 10 Gew.-% gewählt. Gemäß einer weiteren Ausführungsform wird der Anteil der ionischen Verbindung kleiner als 90 Gew.-%, gemäß einer weiteren Ausführungsform kleiner als 60 Gew.-% und gemäß noch einer weiteren Ausführungsform kleiner als 50 Gew.-% gewählt.

Ein weiterer Gegenstand der Erfindung betrifft eine lichtemittierende elektrochemische Zelle enthaltend eine Zusammensetzung wie sie vorgehend beschrieben wurde.

Die lichtemittierende elektrochemische Zelle umfasst zumindest eine Anode sowie zumindest eine Kathode sowie zumindest eine aktive Schicht, welche die oben beschriebene Zusammensetzung enthält bzw. aus dieser aufgebaut ist.

Um eine Emission von Licht aus der aktiven Schicht zu ermöglichen, ist gemäß einer Ausführungsform zumindest eine der Elektroden transparent ausgeführt, sodass Licht durch die Elektrode austreten kann.

Neben oder innerhalb der aktiven Schicht kann die lichtemittierende elektrochemische Zelle weitere funktionelle Schichten umfassen.

Die aktive Schicht kann aus einer einzelnen Schicht aufgebaut sein, welche gemäß einer Ausführungsform einen homogenen Aufbau zeigt.

Es ist aber gemäß einer weiteren Ausführungsform auch möglich, dass die aktive Schicht mehrere Schichten umfasst, die eine unterschiedliche Zusammensetzung aufweisen. Dies kann beispielsweise dazu genutzt werden, die neutrale elektrolumineszierende Verbindung in der Rekombinationszone der aktiven Schicht zu konzentrieren, während in den Bereichen auf die Elektroden zu die neutrale elektrolumineszierende Verbindung nicht oder in geringerer Konzentration vorgesehen ist.

Weiter lässt sich auf diese Weise erreichen, dass beispielsweise unterschiedliche Hostmaterialein in verschiedenen Bereichen der aktiven Schicht eingesetzt werden, und beispielsweise ein elektronentransportierendes Hostmaterial in Bereichen nahe der Kathode und/oder ein lochtransportierendes Material nahe der Anode vorgesehen ist. Ebenso ist es gemäß einer weiteren Ausführungsform möglich, einen Gradienten des elektronentransportierenden bzw. des lochtransportierenden Materials über die Schichtdicke der aktiven Schicht vorzusehen, sodass beispielsweise die Konzentration des elektronentransportierenden Hostmaterials im Bereich der Kathode groß ist und in Richtung auf die Anode hin abnimmt. Analog kann auch für das lochtransportierende Material vorgesehen sein, dass seine Konzentration im Bereich der Anode hoch ist und in Richtung auf die Kathode zu abnimmt.

Gemäß einer Ausführungsform kann auch die Konzentration der ionischen Verbindung über die Dicke der aktiven Schicht hinweg unterschiedlich sein und beispielsweise einen Gradienten aufweisen.

Gemäß einer Ausführungsform kann sich unmittelbar an die Elektrode, beispielsweise die Kathode, ein Bereich anschließen, der eine höhere Konzentration der ionischen Verbindung aufweist als im mittleren Bereich der aktiven Schicht. Auf diese Weise kann nach Anlegen einer Spannung der Übertritt von Elektronen bzw. Löchern aus der Kathode bzw. Anode in die aktive Schicht erleichtert werden.

Gemäß einer Ausführungsform kann sich an die Anode eine Lochinjektionsschicht (HIL) anschließen. Für die Lochinjektionsschicht können übliche Materialien verwendet werden, beispielsweise PEDOT:PSS.

Gemäß einer weiteren Ausführungsform kann sich an die Kathode eine Elektroneninjektionsschicht anschließen.

Die Dicke der aktiven Schicht beträgt gemäß einer Ausführungsform mehr als 10 nm, gemäß einer weiteren Ausführungsform mehr als 100 nm und gemäß noch einer weiteren Ausführungsform mehr als 1 $\mu$m. Gemäß einer Ausführungsform beträgt die Dicke der aktiven Schicht weniger als 100 $\mu$m, gemäß einer weiteren Ausführungsform weniger als 50 $\mu$m, gemäß einer weiteren Ausführungsform weniger als 20 $\mu$m und gemäß einer weiteren Ausführungsform weniger als 10 $\mu$m.

Für die Anode bzw. Kathode der erfindungsgemäßen organischen lichtemittierenden elektrochemischen Zelle

können übliche Materialein verwendet werden. Das Material für die Anode und die Kathode kann gleich oder auch unterschiedlich gewählt werden. Geeignete Materialien sind beispielsweise Metalle, wie Aluminium, Kupfer, Silber, Gold, Magnesium, Eisen, Kobalt, Nickel, Mangan, Zink, Chrom, Vanadium, Palladium, Patin, Gallium, Indium, sowie deren Legierungen, elektrisch leitende Oxide, wie Indium-Zinnoxid (ITO), Aluminium-Zinkoxid (AZO), Fluor-Zinnoxid (FTO), Antimon-Zinkoxid (ATO), ZnO, sowie elektrisch leitende organische Dünnfilme, wie Poly(ethylenedioxythiophen)-polystyrolsulfonat (PEDOT:PSSH), Polyanilin (PANI). Weitere geeignete elektrisch leitende Polymere sind beispielsweise im Review Artikel von Michael S. Freund & Bhavana Deore, in "Self-Doped Conducting Polymers", John Willey & Sons, Ltd., 2007 beschrieben.

Die erfindungsgemäße organische lichtemittierende elektrochemische Zelle ist gemäß einer Ausführungsform auf ein Substrat aufgebracht, wobei übliche Substrate verwendet werden können. Das Substrat kann starr oder flexibel sein. Als Substrat geeignete Materialien sind beispielsweise Glas, Siliziumwafer, oder auch Kunststofffolien. Die Kunststofffolien weisen gemäß einer Ausführungsform eine Glasübergangstemperatur $T_g$ von mehr als 100 °C, gemäß einer weiteren Ausführungsform von mehr als 150 °C und gemäß einer weiteren Ausführungsform von mehr als 180 °C auf. Gemäß einer weiteren Ausführungsform weist die Kunststofffolie eine Glasübergangstemperatur von weniger als 300 °C auf. Die Glasübergangstemperatur von Kunststoffen ist in üblichen Nachschlagewerken, beispielsweise in "Polymer Handbook", Hrsg. J. Brandrup, E. H. Immergut, und E. A. Grulke, John Willey & Sons, Inc., 1999, VI/193-VI/276, beschrieben. Geeignete Substrate sind beispielsweise Polyethylenterephthalat (PET) oder Polyethylene 2,6-naphthalat (PEN).

Um die Lebensdauer der organischen lichtemittierenden elektrochemischen Zelle zu erhöhen und vor einer Zerstörung durch beispielsweise Sauerstoff oder Feuchtigkeit zu schützen, weist die organische lichtemittierende elektrochemische Zelle gemäß einer Ausführungsform eine Verkapselung auf.

Es können übliche Verkapselungen verwendet werden, wie sie beispielsweise auch für OLEDs bekannt sind.

Geeignet besteht die Verkapselung aus einem dünnen Film, welcher aus mehreren alternierend angeordneten anorganischen und organischen Schichten aufgebaut ist. Die anorganischen Schichten wirken dabei als Barriere, während die organische Schicht dazu verwendet wird, unvermeidlich in der anorganischen Schicht auftretende Fehler auszugleichen. Als anorganische Materialien kann beispielsweise Ag, SiOx, $SiN_x$, $AlO_x$, $ZrO_x$, $ZnO_x$, $HfO_x$, $TiO_x$, oder Indium-Zinnoxid verwendet werden. Beispielhafte Verkapselungen aus alternierend angeordneten Schichten aus im Vakuum aufgetragenen Acrylatpolymeren/$AlO_x$ sind beispielsweise von Graff, G. L. et al. (J. Appl. Phys. 2004, 96, 1840), aus $Al_2O_3$/Polyharnstoffschichten von Young Gu Lee et al. (Org. Electron. 2009, 10, 1352 sowie Dig. Tech. Pap.-Soc. Inf. Disp. Int. Symp. 2008, 39, 2011), aus $SiON/SiO_2$/parylen auf PET Substraten von Han, Jin Woo, et al. (Jpn. J. Appl. Phys., Part 1 2006, 45, 9203), sowie aus Polyacrylat (20 μm)-Ag(200 nm) von Wang, Li Duo et al. (Chin. Phys. Lett. 2005, 22, 2684) beschrieben.

Durch Abscheidungstechniken wie Atomlagenabscheidung (ALD), Plasmaunterstützte gepulste Laserabscheidung (PAPLD) oder Plasmaunterstützte chemische Dampfphasenabscheidung (PECVD) kann die Anzahl an Defekten in den anorgansichen Schichten zurückgedrängt werden, sodass auch rein anorgansiche Verkapselungen zugänglich sind.

So werden beispielsweise von Chang,Chih Yu et al. (Org. Electron. 2009, 10, 1300) durch ALD abgeschiedene nanolaminierte $Al_2O_3/HfO_2$ Filme beschrieben. Weitere Beispiele sind SiNx/SiOx Schichtstapel, wie sie von Li,C.Y. et al. (IEEE Electron. Compon. Technol. Conf. 2008, 58th, 1819), (PECVD SiO)/ poly-benzooxazole (PBO) Schichtstapel, wie sie von Shimooka,Y. et al.(IEEE Electron. Compon. Technol. Conf. 2008, 58th, 824), und nanolaminierte Schichtstapel aus $Al_2O_3/ZrO_2$ wie sie von Meyer,J. et al. (Appl. Phys. Lett. 2009, 94, 233305/1) beschrieben sind. Weitere Beispiele sind Nanolaminate aus $Al_2O_3/ZrO_2$ welche durch PAPLD abgeschieden wurden und von Gorrn,Patrick et al. (J. Phys. Chem. 2009, 113, 11126) beschrieben wurden, durch PECVD abgeschiedene SiC Schichten (Weidner,W.K. et al. Annu. Tech. Conf. Proc- Soc. Vac. Coaters 2005, 48th, 158), durch PECVD abgeschiedene Stapel aus Siliziumnitrid - Siliziumoxid - Siliziumnitrid Siliziumoxid - Siliziumnitrid (NONON) (Lifka,H., et al. Dig. Tech. Pap.-Soc. Inf. Disp. Int. Symp. 2004, 35, 1384), sowie Polyethersulfon (PES)/ ALD $AlO_x$ wie sie von Park,Sang-Hee Ko, et al. (ETRI Journal 2005, 545) beschrieben wurden. Eine Übersicht über Verfahren zur Dünnfilmverkapselung ist bei Stoldt, Conrad R, et al.(J. Phys. D: Appl. Phys. 2006, 39, 163) zu finden.

Beispiele für Verkapselungen mit nur einer einzelnen Schicht sind perfluorierte Polymere (Cytop), welche sich aufschleudern lassen (Granstrom, J. et al. Appl. Phys. Lett. 2008, 93, 193304/1), eine Schicht aus Aluminiumoxynitrid ($AlO_xN_y$), welche sich aufsputtern lässt (Huang, L.T. et al. Thin Solid Films 2009, 517, 4207), oder durch PECVD erzeugte SiGe Schichten (Rusu, Cristina et al. (J. Microelectromech. Syst. 2003, 12, 816).

Verfahren zur Verkapselung sind beispielsweise beschrieben in WO 2009/089417, WO 2009/089417, WO 2009/042154, WO 2009/042052, US 2009/081356, US 2009/079328, WO 2008/140313, WO 2008/012460, EP 1868256, KR 2006/084743, KR 2005/023685, US 2005/179379, US 2005/023974, KR 2003/089749, US 2004/170927, US 2004/024105, WO 2003/070625, sowie WO 2001/082390.

Die erfindungsgemäßen Zusammensetzungen und Vorrichtungen zeichnen sich durch einen oder mehrere der folgenden überraschenden Vorteile gegenüber dem Stand der Technik aus:

1. Die erfindungsgemäßen Vorrichtungen weisen sehr gute Stabilitäten und Lebensdauern auf.

2. Die erfindungsgemäßen Vorrichtungen weisen überraschend gute Effizienzen und Spannungen auf.

3. Die erfindungsgemäßen Vorrichtungen können sehr leicht und kostengünstig hergestellt werden und eignen sich daher besonders gut für die Massenproduktion kommerzieller Produkte.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbartes Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn dass sich bestimmte Merkmale und/oder Schritte sich gegenseitig ausschließen. Dies gilt insbesondere für bevor¬zugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbe¬sondere die der bevorzugten Ausführungsformen der vorliegenden Erfin¬dung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die Erfindung wird durch die nachfolgenden Beispiele unter Bezugnahme auf eine Zeichnung näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße Zusammensetzungen sowie erfindungsgemäße lichtemittierende elektrochemische Zellen herstellen. Die Figuren der Zeichnung zeigen:

Fig. 1: Einen Schnitt durch eine erste Ausführungsform einer organischen lichtemittierenden elektrochemischen Zelle;

Fig. 2: Einen Schnitt durch eine zweite Ausführungsform einer organischen lichtemittierenden elektrochemischen Zelle.

**Bestimmungsverfahren**

**Bestimmung von HOMO, LUMO, Singulett- und Triplettniveau**

Die Energieniveaus der Molekülorbitale sowie die Energie des niedrigsten Triplettzustands $T_1$ bzw. des niedrigsten angeregten Singulettzustands $S_1$ der Materialien werden über quantenchemische Rechnungen bestimmt. Hierzu wird vorliegend das Programmpaket "Gaussian09, Revision D.01" (Gaussian Inc.) verwendet. Zur Berechnung organischer Substanzen ohne Metalle (mit Methode "org." bezeichnet) wird zuerst eine Geometrieoptimierung mit der semiempirischen Methode AM1 (Gaussian-Eingabezeile "# AM1 opt") mit der Ladung (Charge) 0 und der Multiplizität (Multiplicity) 1 durchgeführt. Im Anschluss erfolgt auf Grundlage der optimierten Geometrie eine Energierechnung (single point) für den elektronischen Grundzustand und das Triplett-Niveau. Hierbei wird die TDDFT-Methode (time dependent density functional theory) B3PW91 mit dem Basissatz 6-31 G(d) (Gaussian-Eingabezeile "# B3PW91/6-31G(d) td=(50-50,nstates=4)") verwendet (Ladung 0, Multiplizität 1). Für metallorganische Verbindungen (mit Methode "M-org." bezeichnet) wird die Geometrie mit der Methode Hartree-Fock und dem Basissatz LanL2MB (Gaussian-Eingabezeile "# HF/LanL2MB opt") optimiert (Ladung 0, Multiplizität 1). Die Energierechnung erfolgt, wie oben beschrieben, analog zu der der organischen Substanzen, mit dem Unterschied, dass für das Metallatom der Basissatz "LanL2DZ" und für die Liganden der Basissatz "6-31 G(d)" verwendet wird (Gaussian-Eingabezeile "#B3PW91/gen pseudo=lanl2 td=(50-50,nstates=4)"). Aus der Energierechnung erhält man z.B. das HOMO als das letzte mit zwei Elektronen besetze Orbital (Alpha occ. eigenvalues) und LUMO als das erste unbesetzte Orbital (Alpha virt. eigenvalues) in Hartree-Einheiten, wobei HEh und LEh für die HOMO Energie in Hartree-Einheiten beziehungsweise für die LUMO-Energie in Hartree-Einheiten steht. Analog erhält man die Energien in Hartree-Einheiten der anderen Energieniveaus wie HOMO-1, HOMO-2,... LUMO+1, LUMO+2 usw..

Im Sinne dieser Anmeldung werden die anhand von CV Messungen kalibrierten Werte ((HEh*27.212)-0.9899)/1.1206 in eV als Energieniveaus der besetzten Orbitale angesehen.

Im Sinne dieser Anmeldung werden die anhand von CV Messungen kalibrierten Werte ((LEh*27.212)-2.0041)/1.385 in eV als Energieniveaus der unbesetzten Orbitale angesehen.

Der niedrigste Triplettzustand $T_1$ eines Materials ist definiert als die relative Anregungsenergie (in eV) des Triplettzustands mit der niedrigsten Energie, der sich aus der quantenchemischen Energierechnung ergibt.

Der niedrigste angeregte Singulettzustand $S_1$ ist definiert als die relative Anregungsenergie (in eV) des Singulettzustands mit der zweitniedrigsten Energie, der sich aus der quantenchemischen Energierechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.). Vorliegend wird zur Berechnung der Energien das Programmpaket "Gaussian09W" verwendet.

**Bestimmung von Molekülorbitalüberlappungen**

Die Überlappung der Molekülorbitale, die bei bestimmten elektronischen Übergängen beteiligt sind (Charge-Transfer-Zustände) wird mit Hilfe des Parameters $\Lambda$ beschrieben. Dabei ist dem Fachmann die Bedeutung des Parameters $\Lambda$ gut bekannt. Die Bestimmung des Parameters mittels Verfahren, die im Stand der Technik beschrieben sind, bereitet dem Fachmann keinerlei Schwierigkeiten. Im Rahmen der vorliegenden Erfindung wird der Parameter $\Lambda$ anhand der PBHT-Methode gemäß D. J. Tozer et al. (J. Chem. Phys. 128, 044118 (2008)) bestimmt, die beispielsweise in dem Programmpaket Q-Chem 4.1 von Q-Chem, Inc. implementiert ist. Dabei werden die Molekülorbitale gemäß dem oben beschriebenen Verfahren berechnet. Anschließend werden die räumlichen Überlappungen für alle möglichen Paare von besetzten Molekülorbitalen, $\varphi_i$, und unbesetzten (virtuellen) Molekülorbitalen, $\varphi_a$, gemäß folgender Gleichung ermittelt

$$O_{ia} = \langle |\varphi_i| \,|\, |\varphi_a| \rangle$$

wobei für die Berechnung die Beträge der Orbitale verwendet werden.

Der Parameter $\Lambda$ ergibt sich dann aus der gewichteten Summe über alle Paare ia von besetzten und unbesetzten Molekülorbitalen gemäß

$$\Lambda = \frac{\sum_{ia} \kappa_{ia}^2 O_{ia}}{\sum_{ia} \kappa_{ia}^2}$$

wobei der Wert von $\kappa_{ia}$ gemäß Tozer et al. aus den Orbitalkoeffizienten in den Anregungsvektoren der gelösten TD-Eigenwertgleichung (Time-Dependent) ermittelt wird und wobei $0 \leq \Lambda \leq 1$ gilt.

**Bestimmung der PL-Quanteneffizienz (PLQE)**

Von den verwendeten Emissionsschichten wird ein 50 nm dicker Film auf ein Quarzsubstrat aufgebracht. Dieser Film enthält dieselben Materialien in denselben Konzentrationen wie in der Emissionsschicht der entsprechenden OLEC, es sei denn die Emissionsschicht enthält eine oder mehrere weitere Komponenten (z.B. Quantenpunkte, anorganische Halbleiter oder organisch Halbleiter). In diesem Fall enthält der Film zur Messung der PLQE alle Materialien bis auf die weiteren Komponenten, die Mischungsverhältnisse der enthaltenen Materialien entsprechen denen in der Emissionsschicht der OLEC. Bei der Herstellung der Filme zur Messung der PLQE werden die gleichen Herstellungsbedingungen wie bei der Herstellung der Emissionsschicht für die OLECs verwendet. Von dem Film wird ein Absorptionsspektrum im Wellenlängenbereich von 350-500 nm gemessen. Hierzu wird das Reflexionsspektrum $R(\lambda)$ sowie das Transmissionsspektrum $T(\lambda)$ der Probe unter einem Einfallswinkel von 6° (also nahezu senkrechter Einfall) bestimmt. Als Absorptionsspektrum im Sinne dieser Anmeldung wird $A(\lambda)=1-R(\lambda)-T(\lambda)$ definiert.

Gilt $A(\lambda)$ kleiner oder gleich 0.3 im Bereich 350-500 nm, so wird die zum Maximum des Absorptionsspektrums gehörige Wellenlänge im Bereich 350-500 nm als $\lambda$exc definiert. Gilt für irgendeine Wellenlänge $A(\lambda)$ größer als 0.3, so wird als $\lambda$exc die größte Wellenlänge definiert, bei der $A(\lambda)$ von einem Wert kleiner 0.3 zu einem Wert größer 0.3 oder von einem Wert größer 0.3 zu einem Wert kleiner 0.3 wechselt.

Zur Bestimmung der PLQE wird ein Messplatz Hamamatsu C9920-02 verwendet. Das Prinzip beruht auf der Anregung der Probe mit Licht definierter Wellenlänge und der Messung der absorbierten und emittierten Strahlung. Die Probe befindet sich während der Messung in einer Ulbrichtkugel ("integrating sphere"). Das Spektrum des Anregungslichts ist in etwa gaußförmig mit einer Halbwertsbreite von kleiner als 10 nm und Peakwellenlänge $\lambda_{exc}$ wie oben definiert.

Die PLQE wird nach dem für den genannten Messplatz üblichen Auswerteverfahren bestimmt. Es ist strengstens darauf zu achten, dass die Probe zu keinem Zeitpunkt mit Sauerstoff in Berührung kommt, da die PLQE von Materialien mit kleinem energetischen Abstand zwischen $S_1$ und $T_1$ durch Sauerstoff sehr stark reduziert wird (H. Uoyama et al.,

Nature 2012, Vol. 492, 234). Die Messung erfolgt bei Raumtemperatur.

**Bestimmung der Abklingzeit**

Zur Bestimmung der Abklingzeit wird eine Probe verwendet, die wie oben unter "Bestimmung der PL-Quanteneffizienz (PLQE)" beschrieben hergestellt wird. Die Probe wird bei Raumtemperatur durch einen Laserpuls angeregt (Wellenlänge 266 nm, Pulsdauer 1.5 ns, Pulsenergie 200 μJ, Strahldurchmesser 4 mm). Die Probe befindet sich hierbei im Vakuum (weniger als $10^{-5}$ mbar). Nach der Anregung (definiert als t = 0) wird der zeitliche Verlauf der Intensität der emittierten Photolumineszenz gemessen. Die Photolumineszenz zeigt am Anfang einen steilen Abfall, der auf die prompte Fluoreszenz der TADF-Verbindung zurückzuführen ist. Im weiteren zeitlichen Verlauf ist ein langsamerer Abfall zu beobachten, die verzögerte Fluoreszenz (siehe z. B. H. Uoyama et al., Nature, vol. 492, no. 7428, 234-238, 2012 sowie K. Masui et al., Organic Electronics, vol. 14, no. 11, pp. 2721-2726, 2013). Die Abklingzeit $t_a$ im Sinne dieser Anmeldung ist die Abklingzeit der verzögerten Fluoreszenz und wird wie folgt bestimmt: Man wählt einen Zeitpunkt $t_d$ zu dem die prompte Fluoreszenz deutlich unter die Intensität der verzögerten Fluoreszenz abgeklungen ist, so dass die folgende Bestimmung der Abklingzeit nicht von der prompten Fluoreszenz beeinflusst wird. Diese Wahl kann von einem Fachmann durchgeführt werden und gehört zu dessen allgemeinem Fachwissen. Für die Messdaten ab dem Zeitpunkt $t_d$ wird die Abklingzeit $t_a = t_e - t_d$ bestimmt. Dabei ist $t_e$ derjenige Zeitpunkt nach $t = t_d$, bei dem die Intensität erstmals auf 1/e ihres Wertes bei $t = t_d$ abgefallen ist.

**Allgemeines Herstellungsverfahren für die OLECs**

Auf einem Glassubstrat mit vorstrukturierten ITO Anode wird PEDOT:PSS als Lochinjektionsschicht (HIL) aufgebracht. In Abhängigkeit der Beispiele wird auf die HIL eine Lochtransportschicht (HTL) gefolgt von einer Emissionsschicht (EML) oder direkt eine EML aufgetragen. Auf die EML wird eine Al-Kathode aufgebracht.

**Verwendete Materialien**

POL1: Das Polymer kann mittels Suzuki Kupplung (EP 1458783) hergestellt werden.

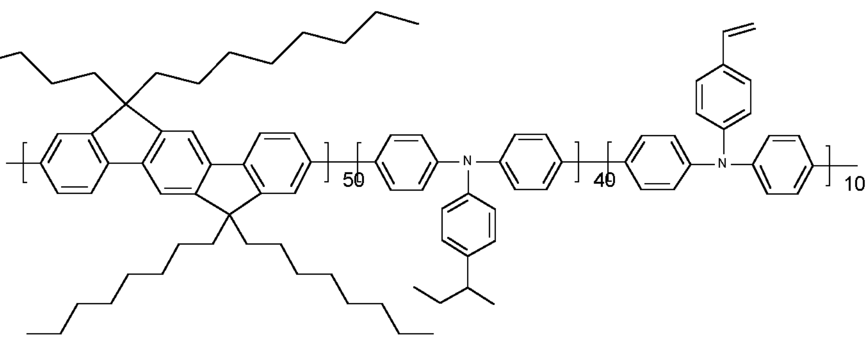

MW: ca. 100 g/mol

E1: C. Adachi et al., Nature, 492, 2012, 234-240

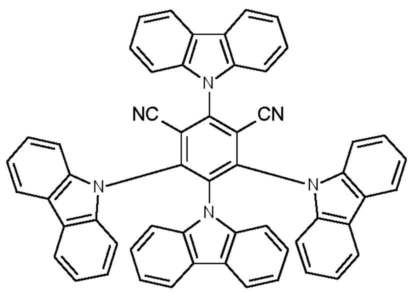

H1: WO 2010/072300A1

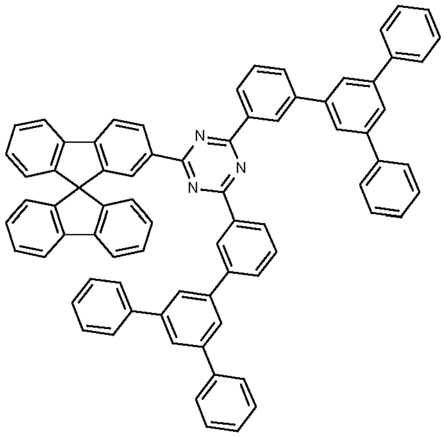

H2: Hergestellt in Analogie zu den Verbindungen in WO 2009/124627A1

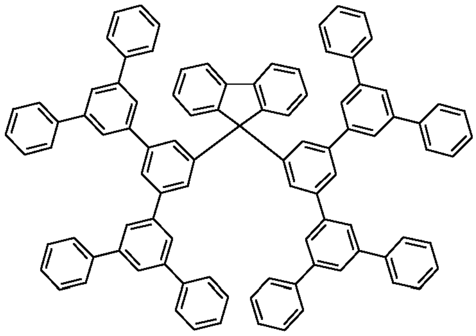

TMPE: Trimethylolpropanethoxylate wird als ionenleitendendes Material eingesetzt. Es handelt sich um ein dreiarm Poly(ethylene oxide) (Aldrich).

$LiCF_3SO_3$: Lithium trifluoromethanesulfonat von Aldrich.

PEO: Poly(ethylenoxid) wird als ionenleitendendes Material eingesetzt. PEO weist ein Molekulargewicht von MW = 5 x $10^6$ auf (Aldrich).

Mit ITO beschichtete und vorstrukturierte Glassubstrate werden in DI-Wasser gereinigt, mittels $N_2$-Pistole getrocknet und dann auf einer Heizplatte bei 180°C für fünf Minuten ausgeheizt. Die HIL (PEDOT) wird aufgeschleudert und dann bei 150°C für 30 Minuten ausgeheizt. Je nach Herstellprozess wird eine HTL aufgeschleudert und für 60 Minuten bei 220°C ausgeheizt. Darauffolgend wird die EML mittels Rotationsbeschichtung aufgebracht. Sie wird für zehn Minuten bei 160°C ausgeheizt. Das Ausheizen der HIL geschieht unter in Luft, HTL und EML werden in Stickstoffatmosphäre ausgeheizt. Die Substrate werden dann in die Hochvakuumbeschichtungsanlage überführt. Darin wir die Kathode (Al) aufgebracht. Dies geschieht mittels thermischer Verdampfung. Danach werden die Substrate in der Glovebox verkapselt und an Luft elektrisch charakterisiert.

**Beispiel 1**

In diesem Beispiel wird EML1 verwendet. Der Schichtaufbau der organischen lichtemittierenden elektrochemischen Zelle ist in Fig. 1 dargestellt. Auf die Anode aus Indium-Zinnoxid (ITO) folgt eine Lochinjektionsschicht auf welcher wiederum eine Emissionsschicht angeordnet ist. Direkt auf der Emissionsschicht ist die Kathode angeordnet.

Die EML Formulierung wurde mit 28.25 mg/ml in Cyclohexanon hergestellt. Materialien und Verhältnisse sind in Tabelle 1 zu finden. Die Schichtdicke betrug insgesamt 100nm. Vor der Messung wurden die Substrate bei 5 Volt für 15 Minuten konditioniert. Das Substrat zeigte grüne Emission. Bei 1000 cd/$m^2$ konnte eine Stromdichte von 11 mA/$cm^2$ und eine Spannung von 3,9 Volt erreicht werden. Damit liegt die Effizienz bei 9,1 cd/A. Es konnte eine Leistungseffizienz von 7,2 lm/W erreicht werden.

**Beispiel 2**

In diesem Beispiel wird EML2 verwendet. Im Übrigen wurde der gleiche Schichtaufbau eingesetzt, wie er in Beispiel 1 verwendet wurde. Die EML Formulierung wurde mit 28.25 mg/ml in Cyclohexanon hergestellt. Materialien und Verhältnisse sind in Tabelle 1 zu finden. Die Schichtdicke betrug insgesamt 100nm. Vor der Messung wurden die Substrate bei 5 Volt für 15 Minuten konditioniert. Das Substrat zeigte grüne Emission. Bei 1000 cd/$m^2$ konnte eine Stromdichte von 12,8 mA/$cm^2$ und eine Spannung von 3,8 Volt erreicht werden. Damit liegt die Effizienz bei 7,8 cd/A. Es konnte eine Leistungseffizienz von 6,3 lm/W erreicht werden.

**Beispiel 3**

In diesem Beispiel wird EML1 verwendet aber mit einem anderen Schichtstapel (Fig. 2). Hier ist im Schichtstaple zwischen Lochinjizierender Schicht und Emissionsschicht noch eine Lochtransportschicht angeordnet. Die HTL Formulierung wurde mit einer Materialkonzentration von 0,5% in Toluol hergestellt. Die HTL Schichtdicke waren 20nm. Die EML Formulierung wurde mit 28.25 mg/ml in Cyclohexanone hergestellt. Materialien und Verhältnisse sind in Tabelle 1 zu finden. Die Endschichtdicke betrug 80nm. Vor der Messung wurden die Substrate bei 5 Volt für 15 Minuten konditioniert. Das Substrat zeigte grüne Emission. Bei 1000 cd/$m^2$ konnte eine Stromdichte von 15,2 mA/$cm^2$ und eine Spannung von 4 Volt. Damit liegt die Effizienz bei 6,6 cd/A. Es konnte eine Leistungseffizienz konnte mit 4,5 lm/W erreicht werden.

Tabelle 1:

| | | | | | |
|---|---|---|---|---|---|
| EML1 | H1 | H2 | E1 | PE0 | $LiCF_3S0_3$ |
| | (26.55%) | (53.1%) | (8.85%) | (8.85%) | (2.65%) |
| EML2 | H1 | H2 | E1 | TMPE | $LiCF_3S0_3$ |
| | (26.55%) | (53.1%) | (8.85%) | (8.85%) | (2.65%) |
| HTL | P0L1 | | | | |

**Patentansprüche**

1. Zusammensetzung umfassend zumindest eine neutrale organische lumineszierende Verbindung sowie zumindest eine ionische Verbindung sowie zumindest ein Hostmaterial, **dadurch gekennzeichnet, dass** die organische lumineszierende Verbindung einen Abstand $S_1$ - $T_1$ zwischen dem niedrigsten Triplett-Zustand $T_1$ und dem ersten angeregten Singulett-Zustand $S_1$ von kleiner oder gleich 0,15 eV aufweist,
wobei die organische lumineszierende Verbindung eine metallfreie organische Verbindung ist, die aus aromatischen Verbindungen ausgewählt ist, die sowohl Donor- als auch Akzeptorsubstituenten aufweisen, wobei die Akzeptorgruppe ausgewählt ist aus der Gruppe bestehend aus CN, $CF_3$, elektronenarmen Heteroarylgruppen und die Donorgruppe ausgewählt ist aus Diarylaminogruppen, Diheteroarylaminogruppen, Carbazolgruppen;
wobei die ionische Verbindung ein Elektrolyt, eine ionische Flüssigkeit oder ein ionischer Übergangsmetallkomplex (iTMC) ist; und
wobei das Hostmaterial einen niedrigsten Triplett-Zustand $T_1^H$ aufweist, der eine Energie aufweist, welche höher liegt als der niedrigsten Triplett-Zustand $T_1$ der neutralen organischen lumineszierenden Verbindung.

2. Zusammensetzung nach Anspruch 1, **dadurch gekennzeichnet, dass** der Abstand $S_1$ - $T_1$ zwischen dem niedrigsten Triplett-Zustand $T_1$ und dem ersten angeregten Singulett-Zustand $S_1$ kleiner oder gleich 0,1 eV, weiter bevorzugt kleiner oder gleich 0,05 eV, insbesondere bevorzugt kleiner oder gleich 0,025 eV ist.

3. Zusammensetzung nach Anspruch 1 oder 2, **dadurch gekennzeichnet, dass** die neutrale organische lumineszierende Verbindung eine kohlenstoffhaltige Verbindung ist, welche aus den Elementen C, H, D, B, Si, N, P, O, S, F, Cl, Br und/oder I aufgebaut ist, bevorzugt aus Elementen aufgebaut ist, ausgewählt aus der Gruppe, welche aus C, H, N und O gebildet ist.

4. Zusammensetzung nach einem der vorhergehenden Ansprüche, **dadurch gekennzeichnet, dass** die neutrale organische lumineszierende Verbindung eine Lumineszenzquanteneffizienz von mindestens 40 % aufweist.

5. Zusammensetzung nach einem der vorhergehenden Ansprüche, **dadurch gekennzeichnet, dass** die neutrale organische lumineszierende Verbindung eine Abklingzeit von kleiner oder gleich 50 μs aufweist.

6. Zusammensetzung nach einem der vorhergehenden Ansprüche, **dadurch gekennzeichnet, dass** die ionische Verbindung ausgewählt ist aus Kalium-Natrium-, Ammonium-, Phosphonium-, Thiouronium- und Guanidiniumsalzen sowie Salzen kationischer aromatischer Heterozyklen.

7. Zusammensetzung nach einem der vorgehenden Ansprüche, **dadurch gekennzeichnet, dass** das Hostmaterial ein loch- oder elektronentransportierendes Material ist.

8. Zusammensetzung nach einem der vorgehenden Ansprüche, **dadurch gekennzeichnet, dass** das Hostmaterial ausgewählt ist aus, Indenofluorenen, Fluorenen, spiro-Bifluorenen, Phentantrenen, Dehydrofluorenen, Thiophenen, Triazinen, Carbazolen, Indenocarbazolen, Indolocarbazolen, Pyrimidine, Lactame, Benzophenonen, Triarlyaminen, Chinazolinen und Imidazolen.

9. Lichtemittierende elektrochemische Zelle enthaltend eine Zusammensetzung nach einem der Ansprüche 1 bis 8.

## Claims

1. Composition comprising at least one uncharged organic luminescent compound and at least one ionic compound and at least one host material, **characterized in that** the organic luminescent compound has a separation $S_1$ - $T_1$ between the lowest triplet state $T_1$ and the first excited singlet state $S_1$ of not more than 0.15 eV,
wherein the organic luminescent compound is a metal-free organic compound which is selected from aromatic compounds having both donor and acceptor substituents, wherein the acceptor group is selected from the group consisting of CN, $CF_3$, electron-deficient heteroaryl groups and the donor group is selected from diarylamino groups, diheteroarylamino groups, carbazole groups; wherein the ionic compound is an electrolyte, an ionic liquid or an ionic transition metal complex (iTMC); and wherein the host material has a lowest triplet state $T_1^H$ having an energy higher than the energy of the lowest triplet state $T_1$ of the uncharged organic luminescent compound.

2. Composition according to Claim 1, **characterized in that** the separation $S_1$ - $T_1$ between the lowest triplet state $T_1$ and the first excited singlet state $S_1$ is not more than 0.1 eV, more preferably not more than 0.05 eV, especially preferably not more than 0.025 eV.

3. Composition according to Claim 1 or 2, **characterized in that** the uncharged organic luminescent compound is a carbon compound formed from the elements C, H, D, B, Si, N, P, 0, S, F, Cl, Br and/or I, preferably formed from elements selected from the group formed from C, H, N and O.

4. Composition according to any of the preceding claims, **characterized in that** the uncharged organic luminescent compound has a luminescence quantum efficiency of at least 40%.

5. Composition according to any of the preceding claims, **characterized in that** the uncharged organic luminescent compound has a decay time of not more than 50 μs.

6. Composition according to any of the preceding claims, **characterized in that** the ionic compound is selected from potassium, sodium, ammonium, phosphonium, thiouronium and guanidinium salts and salts of cationic aromatic heterocycles.

7. Composition according to any of the preceding claims, **characterized in that** the host material is a hole- or electron-transporting material.

8. Composition according to any of the preceding claims, **characterized in that** the host material is selected from indenofluorenes, fluorenes, spiro-bifluorenes, phenanthrenes, dehydrofluorenes, thiophenes, triazines, carbazoles, indenocarbazoles, indolocarbazoles, pyrimidines, lactams, benzophenones, triarylamines, quinazolines and imidazoles.

9. Light-emitting electrochemical cell comprising a composition according to any of Claims 1 to 8.

**Revendications**

1. Composition comprenant au moins un composé luminescent organique neutre ainsi qu'au moins un composé ionique ainsi qu'au moins un matériau hôte, **caractérisée en ce que** le composé luminescent organique présente une distance $S_1$-$T_1$ entre l'état triplet le plus bas $T_1$ et le premier état singulet excité $S_1$ inférieure ou égale à 0,15 eV, le composé luminescent organique étant un composé organique exempt de métal, qui est choisi parmi les composés aromatiques qui présentent à la fois des substituants donneurs et accepteurs, le groupe accepteur étant choisi dans le groupe constitué par CN, $CF_3$, les groupes hétéroaryle pauvres en électrons et le groupe donneur étant choisi parmi les groupes diarylamino, les groupes dihétéroarylamino, les groupes carbazole ;
le composé ionique étant un électrolyte, un liquide ionique ou un complexe ionique de métal de transition (iTMC) ; et le matériau hôte présentant un état triplet le plus bas $T_1^H$ qui présente une énergie qui est supérieure à l'état triplet le plus bas $T_1$ du composé luminescent organique neutre.

2. Composition selon la revendication 1, **caractérisée en ce que** la distance $S_1$-$T_1$ entre l'état triplet le plus bas $T_1$ et le premier état singulet excité $S_1$ est inférieure ou égale à 0,1 eV, plus préférablement inférieure ou égale à 0,05 eV, en particulier de préférence inférieure ou égale à 0,025 eV.

3. Composition selon la revendication 1 ou 2, **caractérisée en ce que** le composé luminescent organique neutre est un composé carboné, qui est constitué par les éléments C, H, D, B, Si, N, P, 0, S, F, Cl, Br et/ou I, de préférence constitué par les éléments choisis dans le groupe qui est formé par C, H, N et 0.

4. Composition selon l'une quelconque des revendications précédentes, **caractérisée en ce que** le composé luminescent organique neutre présente une efficacité quantique de luminescence d'au moins 40%.

5. Composition selon l'une quelconque des revendications précédentes, **caractérisée en ce que** le composé luminescent organique neutre présente un temps d'extinction inférieur ou égal à 50 $\mu$s.

6. Composition selon l'une quelconque des revendications précédentes, **caractérisée en ce que** le composé ionique est choisi parmi les sels de potassium, de sodium, d'ammonium, de phosphonium, de thio-uronium et de guanidinium ainsi que les sels d'hétérocycles aromatiques cationiques.

7. Composition selon l'une quelconque des revendications précédentes, **caractérisée en ce que** le matériau hôte est un matériau transportant des trous ou des électrons.

8. Composition selon l'une quelconque des revendications précédentes, **caractérisée en ce que** le matériau hôte est choisi parmi les indénofluorènes, les fluorènes, les spiro-bifluorènes, les phénanthrènes, les déshydrofluorènes, les thiophènes, les triazines, les carbazoles, les indénocarbazoles, les indolocarbazoles, les pyrimidines, les lactames, les benzophénones, les triarylamines, les quinazolines et les imidazoles.

9. Cellule électrochimique électroluminescente de lumière contenant une composition selon l'une quelconque des revendications 1 à 8.

Fig. 1

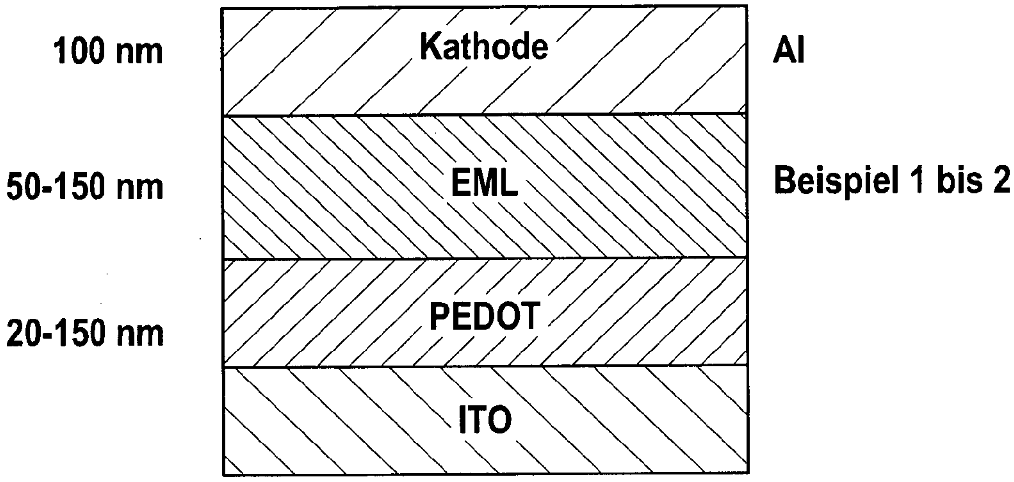
100 nm
Kathode
Al
50-150 nm
EML
Beispiel 1 bis 2
20-150 nm
PEDOT
ITO

Fig. 2

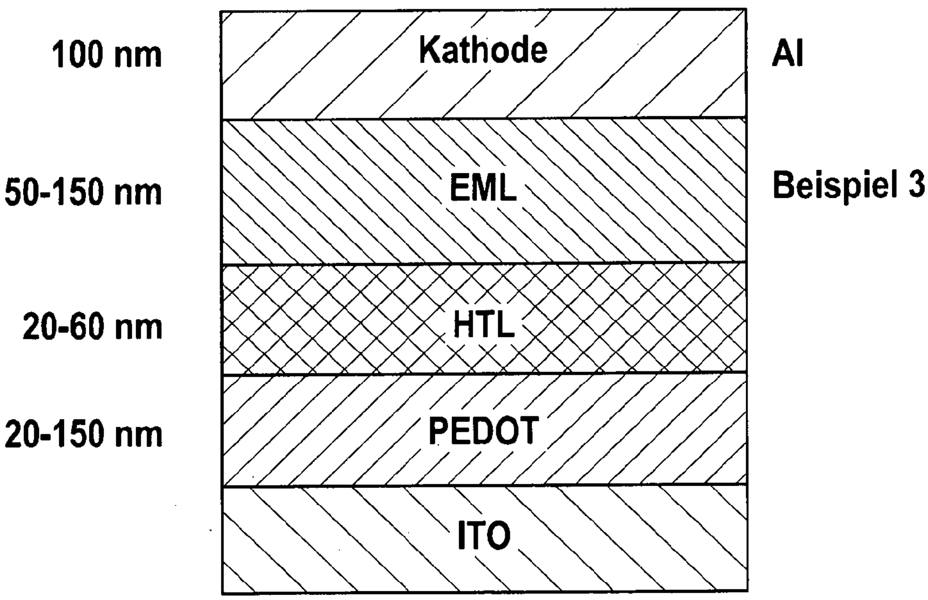
100 nm
Kathode
Al
50-150 nm
EML
Beispiel 3
20-60 nm
HTL
20-150 nm
PEDOT
ITO

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2013173845 A
- EP 2733188 A
- WO 2014094965 A
- WO 2013154064 A
- WO 2013161437 A
- WO 2013081088 A
- WO 2013011954 A
- US 20070262694 A1
- EP 676461 A
- WO 2004081017 A
- US 20070092753 A1
- WO 2004058911 A
- WO 2005084081 A
- WO 200508408 A
- WO 2006048268 A
- WO 2006117052 A
- DE 102007024850
- US 20070252517 A1
- US 20080193796 A1
- US 5121029 A
- US 20030027016 A1
- US 7326371 B2
- US 2006043858 A
- WO 2007114358 A
- WO 2008145239 A
- JP 3148176 B
- EP 1009044 A
- US 2004018383 A
- WO 2005061656 A1
- EP 0681019 B1
- WO 2004013073 A1
- US 5077142 A
- WO 2007065678 A
- US 20070205412 A1
- EP 0676461 A
- US 6562485 B
- WO 2009089417 A
- WO 2009042154 A
- WO 2009042052 A
- US 2009081356 A
- US 2009079328 A
- WO 2008140313 A
- WO 2008012460 A
- EP 1868256 A
- KR 2006084743
- KR 2005023685
- US 2005179379 A
- US 2005023974 A
- KR 2003089749
- US 2004170927 A
- US 2004024105 A
- WO 2003070625 A
- WO 2001082390 A
- EP 1458783 A
- WO 2010072300 A1
- WO 2009124627 A1


### In der Beschreibung aufgeführte Nicht-Patentliteratur


- **B. H. UOYAMA et al.** *Nature,* 2012, vol. 492, 234
- **VON OUIBING PEI et al.** *Science,* 1995, vol. 296, 1086-1088
- **TANAKA et al.** *Chemistry of Materials,* 2013, vol. 25 (18), 3766
- **ZHANG et al.** *Nature Photonics advance,* 2014, vol. 1
- **SEREVICIUS et al.** *Physical Chemistry Chemical Physics,* 2013, vol. 15 (38), 15850
- **YOUN LEE et al.** *Applied Physics Letters,* 2012, vol. 101 (9), 093306
- **NASU et al.** *ChemComm,* 2013, vol. 49, 10385
- **RUDMANN et al.** *J. Am. Chem. Soc.,* 2002, vol. 124, 4918-4921
- **ROTHE et al.** *Adv. Func. Mater.,* 2009, vol. 19, 2038-2044
- **MICHAEL S. FREUND ; BHAVANA DEORE.** Self-Doped Conducting Polymers. John Willey & Sons, Ltd, 2007
- Polymer Handbook. John Willey & Sons, Inc, 1999, VI/193-VI/276
- **GRAFF, G. L. et al.** *J. Appl. Phys.,* 2004, vol. 96, 1840
- **YOUNG GU LEE et al.** *Org. Electron.,* 2009, vol. 10, 1352
- *Dig. Tech. Pap.-Soc. Inf. Disp. Int. Symp.,* 2008, vol. 39, 2011
- **HAN, JIN WOO et al.** *Jpn. J. Appl. Phys.,* 2006, vol. 45, 9203
- **WANG, LI DUO et al.** *Chin. Phys. Lett.,* 2005, vol. 22, 2684

- **CHANG,CHIH YU et al.** *Org. Electron.,* 2009, vol. 10, 1300
- **LI,C.Y. et al.** *IEEE Electron. Compon. Technol. Conf.,* 2008, vol. 1819
- **SHIMOOKA,Y. et al.** *IEEE Electron. Compon. Technol. Conf.,* 2008, vol. 824
- **MEYER,J. et al.** *Appl. Phys. Lett.,* 2009, vol. 94, 233305, , 1
- **GORRN,PATRICK et al.** *J. Phys. Chem.,* 2009, vol. 113, 11126
- **WEIDNER,W.K. et al.** *Annu. Tech. Conf. Proc- Soc. Vac. Coaters,* 2005, vol. 158
- **LIFKA,H. et al.** *Dig. Tech. Pap.-Soc. Inf. Disp. Int. Symp.,* 2004, vol. 35, 1384
- **PARK,SANG-HEE KO et al.** *ETRI Journal,* 2005, vol. 545
- **STOLDT, CONRAD R et al.** *J. Phys. D: Appl. Phys.,* 2006, vol. 39, 163
- **GRANSTROM, J. et al.** *Appl. Phys. Lett.,* 2008, vol. 93, 193304, , 1
- **HUANG, L.T. et al.** *Thin Solid Films,* 2009, vol. 517, 4207
- **RUSU, CRISTINA et al.** *J. Microelectromech. Syst.,* 2003, vol. 12, 816
- **D. J. TOZER et al.** *J. Chem. Phys.,* 2008, vol. 128, 044118
- **H. UOYAMA et al.** *Nature,* 2012, vol. 492, 234
- **B. H. UOYAMA et al.** *Nature,* 2012, vol. 492 (7428), 234-238
- **K. MASUI et al.** *Organic Electronics,* 2013, vol. 14 (11), 2721-2726
- **C. ADACHI et al.** *Nature,* 2012, vol. 492, 234-240